# EUROPEAN PATENT APPLICATION

(11) **EP 4 478 608 A1**
(43) Date of publication of application: **18.12.2024**
(21) Application number: 23752922.7
(22) Date of filing: 08.02.2023
(51) Int. Cl.: H03F 1/02, H03F 3/24

(54) **TRACKER MODULE, POWER AMPLIFICATION MODULE, AND HIGH FREQUENCY MODULE**

(30) Priority: 10.02.2022 US 202263308691 P
(71) Applicant: Murata Manufacturing Co., Ltd., Nagaokakyo-shi, Kyoto 617-8555 (JP)
(72) Inventor: HOVERSTEN, John, Cambridge, Massachusetts 02142 (US); TKACHENKO, Yevgeniy, Cambridge, Massachusetts 02142 (US); PERREAULT, David, Cambridge, Massachusetts 02142 (US); YAMAMOTO, Muneyoshi, Nagaokakyo-shi, Kyoto 617-8555 (JP); KOGURE, Takeshi, Nagaokakyo-shi, Kyoto 617-8555 (JP)
(74) Representative: Stöckeler, Ferdinand
(86) International application number: PCT/JP2023/004258
(87) International publication number: WO 2023/153458

(57) **Abstract**

A tracker module (100A) includes a module laminate (90), an integrated circuit (80) arranged on the module laminate (90), and an output terminal (141) that is capable of being externally connected and multiple output terminals (121 to 124). The integrated circuit (80) includes at least one switch included in a switched-capacitor circuit (20) and at least one switch included in a supply modulator (30A). The switched-capacitor circuit (20) is configured so as to generate multiple discrete voltages based on input voltage and to supply the generated multiple discrete voltages to the supply modulator (30A) and the multiple output terminals (121 to 124). The supply modulator (30A) is configured so as to selectively output at least one of the multiple discrete voltages generated by the switched-capacitor circuit (20).

## Description

### Technical Field

The present invention relates to a tracker module, a power amplifier module, and a radio-frequency module.

### Background Art

Connection to multiple different wireless networks is required in mobile communication devices, such as mobile phones. For example, in common smartphones, connection to a cellular network based on standards (for example, 5th Generation New Radio (5GNR) and Long Term Evolution (LTE)) developed by 3rd Generation Partnership Project (3GPP) (registered trademark), a wireless local area network (WLAN) based on standards (for example, Institute of Electrical and Electronics Engineers (IEEE) 802.11xx) developed by the IEEE, and a wireless personal area network (WPAN) based on Bluetooth (registered trademark) developed by Bluetooth Special Interest Group (Bluetooth SIG) is required. In addition, in the 5GNR, a frequency range (Frequency Range 2 (FR2)) from 24,250 MHz to 52,600 MHz is used, in addition to a frequency range (Frequency Range 1 (FR1)) from 450 MHz to 6,000 MHz.

In the mobile communication devices, a tracking mode to dynamically adjust power supply voltage to be supplied to a power amplifier is used in order to improve power-added efficiency (PAE). In Patent Document 1, the power supply voltages having multiple variable discrete voltage levels are supplied to power amplifiers based on an envelope signal to improve the PAE.

### Citation List

### Patent Document

Patent Document 1: U.S. Patent No. 9,768,731

### Summary of Invention

### Technical Problem

However, with the technique disclosed in Patent Document 1, the power supply voltage to be supplied to the power amplifier may be degraded.

In order to resolve the above problem, the present invention provides a tracker module, a power amplifier module, and a radio-frequency module, which are capable of suppressing the degradation of the power supply voltage that is to be supplied to the power amplifier and that has multiple variable discrete voltage levels.

### Solution to Problem

A tracker module according to one aspect of the present invention includes a module laminate, at least one integrated circuit arranged on the module laminate, and a first output terminal that is capable of being externally connected and multiple second output terminals. The at least one integrated circuit includes at least one switch included in a switched-capacitor circuit and at least one switch included in a first supply modulator. The switched-capacitor circuit is configured so as to generate multiple discrete voltages based on input voltage and to supply the generated multiple discrete voltages to the first supply modulator and the multiple second output terminals. The first supply modulator is configured so as to selectively supply at least one of the multiple discrete voltages generated by the switched-capacitor circuit to the first output terminal.

A power amplifier module according to one aspect of the present invention includes a module laminate, a power amplifier that is arranged on the module laminate and that is configured so as to amplify a radio-frequency signal, an integrated circuit arranged on the module laminate, and multiple input terminals receiving the corresponding multiple discrete voltages. The integrated circuit includes a supply modulator configured so as to selectively supply at least one of the multiple discrete voltages received via the multiple input terminals to the power amplifier based on the radio-frequency signal.

A radio-frequency module according to one aspect of the present invention includes a first substrate having multiple output terminals, a second substrate having multiple first input terminals connected to the corresponding multiple output terminals, a first integrated circuit that includes at least one switch included in a switched-capacitor circuit and that is arranged on the first substrate, and a second integrated circuit that includes at least one switch included in a supply modulator and that is arranged on the second substrate. The switched-capacitor circuit is configured so as to generate multiple discrete voltages based on input voltage and to supply the generated multiple discrete voltages to the multiple output terminals. The supply modulator is configured so as to selectively output at least one of the multiple discrete voltages received via the multiple first input terminals.

### Advantageous Effects of Invention

According to the tracker module according to one aspect of the present invention, it is possible to suppress degradation of the power supply voltage that is to be supplied to the power amplifier and that has multiple variable discrete voltage levels.

### Brief Description of Drawings

[Fig. 1A] Fig. 1A is a graph indicating an example of transition of power supply voltage in an average power tracking mode.
[Fig. 1B] Fig. 1B is a graph indicating an example of transition of the power supply voltage in an analog envelope tracking mode.
[Fig. 1C] Fig. 1C is a graph indicating an example of transition of the power supply voltage in a digital envelope tracking mode.
[Fig. 2] Fig. 2 is a diagram illustrating the circuit configuration of a communication device according to a first embodiment.
[Fig. 3A] Fig. 3A is a diagram illustrating the circuit configurations of a pre-regulator circuit, a switched-capacitor circuit, supply modulators, and a filter circuit according to the first embodiment.
[Fig. 3B] Fig. 3B is a diagram illustrating the circuit configuration of a digital control circuit according to the first embodiment.
[Fig. 4] Fig. 4 is a flowchart illustrating a power supply voltage supplying method according to the first embodiment.
[Fig. 5] Fig. 5 is a diagram illustrating how modules are arranged on a mother board in the first embodiment.
[Fig. 6] Fig. 6 is a plan view of a tracker module according to the first embodiment.
[Fig. 7] Fig. 7 is a plan view of the tracker module according to the first embodiment.
[Fig. 8] Fig. 8 is a cross-sectional view of the tracker module according to the first embodiment.
[Fig. 9] Fig. 9 is a plan view of PA modules according to the first embodiment.
[Fig. 10] Fig. 10 is a plan view of the PA modules according to the first embodiment.
[Fig. 11] Fig. 11 is a diagram illustrating how modules are arranged on the mother board in a second embodiment.
[Fig. 12] Fig. 12 is a plan view of a tracker module according to the second embodiment.
[Fig. 13] Fig. 13 is a diagram illustrating how modules are arranged on the mother board in a third embodiment.
[Fig. 14] Fig. 14 is a plan view of a PA module according to the third embodiment.
[Fig. 15] Fig. 15 is a plan view of the PA module according to the third embodiment.
[Fig. 16] Fig. 16 is a diagram illustrating the circuit configuration of a communication device according to a fourth embodiment.
[Fig. 17] Fig. 17 is a diagram illustrating how modules are arranged on the mother board in the fourth embodiment.
[Fig. 18] Fig. 18 is a diagram illustrating how modules are arranged on the mother board in a fifth embodiment.
[Fig. 19] Fig. 19 is a diagram illustrating a partial circuit configuration of a communication device according to another embodiment.

### Description of Embodiments

Embodiments of the present invention will herein be described in detail with reference to the drawings. All the embodiments described below indicate comprehensive or specific examples. Numerical values, shapes, materials, components, the arrangement of the components, the connection mode of the components, and so on, which are indicated in the embodiments described below, are only examples and are not intended to limit the present invention.

The respective drawings are schematic diagrams appropriately subjected to emphasis, omission, or adjustment of ratios in order to describe the present invention. The respective drawings are not necessarily strictly illustrated and may be different from the actual shapes, positional relationship, and ratios. The same reference numerals and letters are used in the respective drawings to identify substantially the same components and a duplicated description of such components may be omitted or simplified.

In the drawings described below, the x axis and the y axis are axes that are orthogonal to each other on a plane parallel to the main surfaces of a module laminate. Specifically, when the module laminate has a rectangular shape in a plan view, the x axis is parallel to a first side of the module laminate and the y axis is parallel to a second side orthogonal to the first side of the module laminate. The z axis is an axis vertical to the main surfaces of the module laminate. The positive direction of the z axis indicates the upper direction and the negative direction thereof indicates the lower direction.

In the circuit configurations of the present invention, "connected" includes not only direct connection with a connection terminal and/or a wiring conductor but also electrical connection via another circuit element. "Connected between A and B" means connection to both A and B between A and B and means series connection to a path between A and B.

In the arrangement of components of the present invention, "arrangement of a component on a module laminate" includes arrangement of the component on the main surface of the module laminate and arrangement of the component in the module laminate. The "arrangement of a component on the main surface of the module laminate" includes arrangement of the component above the main surface without being in contact with the main surface (for example, laminating of the component on another component arranged on the main surface with being in contact with the main surface), in addition to arrangement of the component on the main surface with being in contact with the main surface of the module laminate. In addition, the "arrangement of a component on the main surface of the module laminate" may include arrangement of the component in a depression formed in the main surface. The "arrangement of a component in the module laminate" includes a situation in which the entire component is arranged between the main surfaces of the module laminate but part of the component is not covered with the module laminate and a situation in which only part of the component is arranged in the module laminate, in addition to a situation in which the component is capsulated in the module laminate.

The terms, such as parallel and vertical, indicating the relationship between elements; the terms, such as rectangles, indicating the shapes of the elements; and numerical ranges do not represent only strict meanings but mean substantially the same ranges, for example, inclusion of differences on the order of few percent.

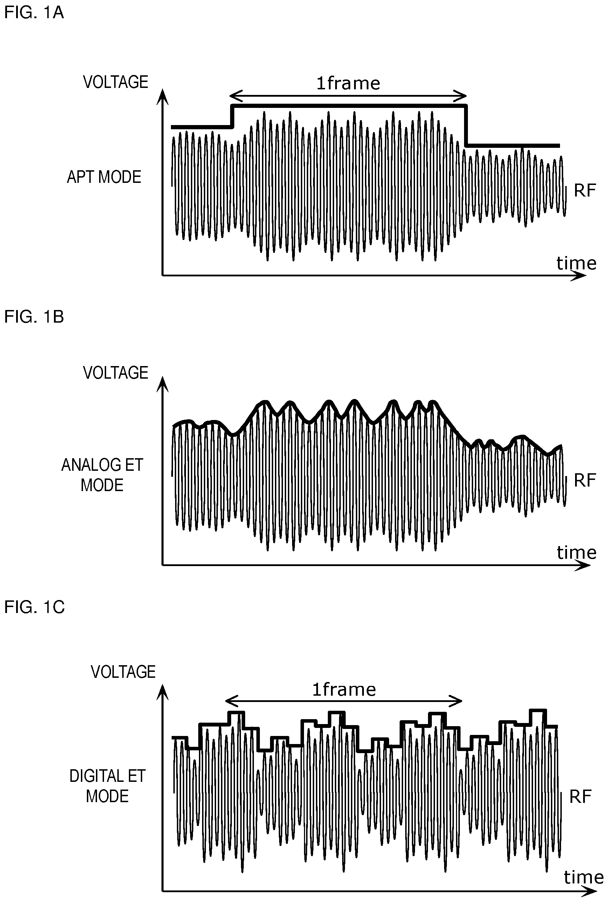

Tracking modes to supply power supply voltage that is dynamically adjusted with time based on a radio-frequency signal to a power amplifier will now be described as techniques to efficiently amplify the radio-frequency signal. The tracking modes are modes in which the power supply voltage to be supplied to the power amplifier is dynamically adjusted. Several kinds of the tracking modes are used. Here, an average power tracking (APT) mode, envelope tracking (ET) modes (including an analog ET mode and a digital ET mode) will be described with reference to Fig. 1A to Fig. 1C. Referring to Fig. 1A to Fig. 1C, the horizontal axis represents time and the vertical axis represents voltage. A bold solid line represents the power supply voltage and a thin solid line (waveform) represents a modulated signal.

Fig. 1A is a graph indicating an example of transition of the power supply voltage in the APT mode. In the APT mode, the power supply voltage is varied at multiple discrete voltage levels in units of frames. As a result, the power supply voltage signal forms rectangular waves. The voltage level of the power supply voltage is determined based on average output power in the APT mode. In the APT mode, the voltage level may be varied in units of, for example, sub-frames, slots, or symbols, which are smaller than one frame. The APT in which the voltage level is varied in units of symbols may be called symbol power tracking (SPT).

The frame means a unit composing the radio-frequency signal (the modulated signal). For example, in the 5GNR and the LTE, the frame includes 10 sub-frames, each sub-frame includes multiple slots, and each slot is composed of multiple symbols. The sub-frame length is 1 ms and the frame length is 10 ms.

Fig. 1B is a graph indicating an example of transition of the power supply voltage in the analog ET mode. The analog ET mode is an example of the ET mode in related art. In the analog ET mode, the power supply voltage is continuously varied to track the envelope of the modulated signal, as illustrated in FIG 1B. The power supply voltage is determined based on an envelope signal in the analog ET mode.

The envelope signal is a signal indicating the envelope of the modulated signal. The envelope value is represented by, for example, a square root of (I2+Q2). Here, (I, Q) represents a constellation point. The constellation point is a point representing a signal modulated through digital modulation on a constellation diagram. (I, Q) is determined in a baseband integrated circuit (BBIC) 4 based on, for example, transmission information.

Fig. 1C is a graph indicating an example of transition of the power supply voltage in the digital ET mode. In the digital ET mode, the power supply voltage is varied at the multiple discrete voltage levels in one frame to track the envelope of the modulated signal, as indicated in Fig. 1C. As a result, the power supply voltage signal forms the rectangular waves. In the digital ET mode, the power supply voltage level is selected or set from the multiple discrete voltage levels based on the envelope signal.

### (First embodiment)

A first embodiment will now be described. A communication device 7 according to the present embodiment is capable of being used to provide wireless connection. For example, the communication device 7 is capable of being mounted in user equipment (UE) in a cellular network of, for example, a mobile phone, a smartphone, a tablet computer, or a wearable device. In another example, the wireless connection is capable of being provided to an Internet of Things (IoT) sensor device, a medical-health care device, a vehicle, an unmanned aerial vehicle (UAV) (a so-called drone), and an automated guided vehicle (AGV) by mounting the communication device 7. In another example, the wireless connection is also capable of being provided at a wireless access point or a wireless hot spot by mounting the communication device 7.

### [1.1 Circuit configuration of communication device 7]

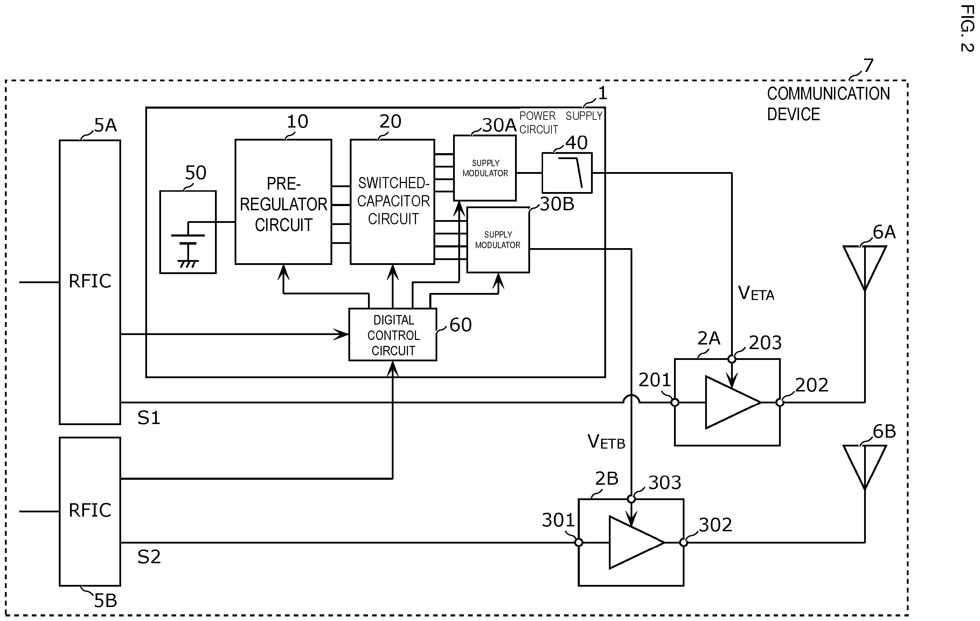

First, the circuit configuration of the communication device 7 will be described with reference to Fig. 2. Fig. 2 is a diagram illustrating the circuit configuration of the communication device 7 according to the present embodiment. As illustrated in Fig. 2, the communication device 7 according to the present embodiment includes a power supply circuit 1, power amplifiers 2A and 2B, radio-frequency integrated circuits (RFICs) 5A and 5B, and antennas 6A and 6B.

The power supply circuit 1 is capable of supplying power supply voltage V_{ETA} and power supply voltage V_{ETB} to the power amplifiers 2A and 2B, respectively, in the digital ET mode. As described above with reference to Fig. 1C, in the digital ET mode, the voltage level of each of the power supply voltages V_{ETA} and V_{ETB} is selected from the multiple discrete voltage levels based on the envelope signal and is varied with time.

Although the power supply circuit 1 supplies the two power supply voltages V_{ETA} and V_{ETB} to the two power amplifiers 2A and 2B, respectively, in Fig. 2, the power supply circuit 1 may supply the same power supply voltage to multiple power amplifiers.

As illustrated in Fig. 2, the power supply circuit 1 includes a pre-regulator circuit 10, a switched-capacitor circuit 20, supply modulators 30A and 30B, a filter circuit 40, a direct current power source 50, and a digital control circuit 60.

The pre-regulator circuit 10 includes a power inductor and switches. The power inductor is an inductor used to step up and/or step down direct current voltage. The power inductor is arranged in series on a direct-current path. The power inductor may be connected (arranged in parallel) between a series path and ground. The pre-regulator circuit 10 is capable of converting input voltage into first voltage using the power inductor. Such a pre-regulator circuit 10 may be called a magnetic regulator or a direct current (DC)-DC converter. The pre-regulator circuit 10 does not necessarily include the power inductor.

The switched-capacitor circuit 20 includes multiple capacitors and multiple switches and is capable of generating multiple second voltages having the corresponding multiple discrete voltage levels from the first voltage from the pre-regulator circuit 10. The switched-capacitor circuit 20 may be called a switched-capacitor voltage ladder.

Each of the supply modulators 30A and 30B is capable of selectively outputting at least one of the multiple second voltages generated in the switched-capacitor circuit 20 based on a digital control signal corresponding to the envelope signal. As a result, at least one voltage selected from the multiple second voltages is output from each of the supply modulators 30A and 30B. Each of the supply modulators 30A and 30B is capable of varying output voltage with time by repeating the above selection of the voltage with time. Each of the supply modulators 30A and 30B may be called a supply modulator circuit.

Since various circuit elements and/or wirings that generate voltage drop, noise, and/or the like can be included in the supply modulators 30A and 30B, the time waveform of the output voltage from each of the supply modulators 30A and 30B is not necessarily the rectangular waves including only the multiple second voltages. In other words, the output voltage from each of the supply modulators 30A and 30B may include voltage different from the multiple second voltages.

The filter circuit 40 is capable of filtering the signal (the second voltage) from the supply modulator 30A.

The direct current power source 50 is capable of supplying the direct current voltage to the pre-regulator circuit 10. Although, for example, a rechargeable battery is capable of being used as the direct current power source 50, the direct current power source 50 is not limited to this.

The digital control circuit 60 is capable of controlling the pre-regulator circuit 10, the switched-capacitor circuit 20, and the supply modulators 30A and 30B based on the digital control signals from the RFICs 5A and 5B.

As described above, the pre-regulator circuit 10 and the switched-capacitor circuit 20 are shared between the two power amplifiers 2A and 2B, and the supply modulators 30A and 30B are separately used in the two power amplifiers 2A and 2B.

The power supply circuit 1 does not necessarily include at least one of the pre-regulator circuit 10, the switched-capacitor circuit 20, the supply modulators 30A and 30B, the filter circuit 40, the direct current power source 50, and the digital control circuit 60. For example, the power supply circuit 1 does not necessarily include the filter circuit 40. The power supply circuit 1 does not necessarily include the direct current power source 50. An arbitrary combination of the pre-regulator circuit 10, the switched-capacitor circuit 20, the supply modulators 30A and 30B, and the filter circuit 40 may be integrated into one circuit.

The power amplifier 2A is an example of a first power amplifier capable of amplifying a radio-frequency signal S1 and is connected between the RFIC 5A and the antenna 6A. The power amplifier 2A is further connected to the power supply circuit 1. Specifically, the power amplifier 2A has an input terminal 201, an output terminal 202, and a power supply terminal 203. The input terminal 201 is connected to the RFIC 5A and receives the radio-frequency signal S1 from the RFIC 5A. The output terminal 202 is connected to the antenna 6A and the radio-frequency signal S1 that is amplified is output from the output terminal 202. The power supply terminal 203 is connected to the power supply circuit 1 and receives the power supply voltage V_{ETA}. In this connection configuration, the power amplifier 2A is capable of amplifying the radio-frequency signal S1 received from the RFIC 5A and outputting the amplified radio-frequency signal S1 using the power supply voltage V_{ETA} supplied from the power supply circuit 1.

The radio-frequency signal S1 is an example of a first radio-frequency signal and is a wireless communication signal in a communication network that is built using a radio access technology (RAT). In the present embodiment, the radio-frequency signal S1 is a cellular network signal and, more specifically, a cellular network Sub6 signal. The Sub6 signal means a signal in a frequency band lower than 6 gigahertz. In the 5GNR, the Sub6 signal is a signal in a frequency band included in the FR1.

The power amplifier 2B is an example of a second power amplifier capable of amplifying a radio-frequency signal S2 and is connected between the RFIC 5B and the antenna 6B. The power amplifier 2B is further connected to the power supply circuit 1. Specifically, the power amplifier 2B has an input terminal 301, an output terminal 302, and a power supply terminal 303. The input terminal 301 is connected to the RFIC 5B and receives the radio-frequency signal S2 from the RFIC 5B. The output terminal 302 is connected to the antenna 6B and the radio-frequency signal S2 that is amplified is output from the output terminal 302. The power supply terminal 303 is connected to the power supply circuit 1 and receives the power supply voltage V_{ETB}. In this connection configuration, the power amplifier 2B is capable of amplifying the radio-frequency signal S2 received from the RFIC 5B and outputting the amplified radio-frequency signal S2 using the power supply voltage V_{ETB} supplied from the power supply circuit 1.

The radio-frequency signal S2 is an example of a second radio-frequency signal and is a wireless communication signal in a communication network that is built using the RAT. Although a WLAN 2.4-GHz band or 5-GHz band signal or a cellular network millimeter-wave signal is capable of being used as the radio-frequency signal S2, the WLAN 2.4-GHz band signal is used as the radio-frequency signal S2 in the present embodiment.

Although the millimeter-wave signal generally means a signal in a frequency band included in 30 GHz to 300 GHz, the millimeter-wave signal means a signal in a frequency band included in 24,250 MHz to 52,600 MHz (the FR2 in the 5GNR) here.

The RFICs 5A and 5B are examples of signal processing circuits that process the radio-frequency signals S1 and S2, respectively. Specifically, the RFICs 5A and 5B perform signal processing, such as up-conversion, of a transmission signal that is input and supply the radio-frequency signals S1 and S2 generated through the signal processing to the power amplifiers 2A and 2B, respectively. The RFICs 5A and 5B each include a controller that controls the power supply circuit 1. Part or all of the functions as the controllers of the RFICs 5A and 5B may be mounted outside the RFICs 5A and 5B (for example, a tracker module described below).

The radio-frequency signal S1 input from the power amplifier 2A is transmitted from the antenna 6A. The radio-frequency signal S2 input from the power amplifier 2B is transmitted from the antenna 6B. The antenna 6A and/or the antenna 6B is not necessarily included in the communication device 7.

The circuit configuration of the communication device 7 represented in Fig. 2 is only an example and is not limited to this. For example, the communication device 7 may include a filter between the power amplifier 2A and the antenna 6A and/or may include a filter between the power amplifier 2B and the antenna 6B.

In addition, for example, the communication device 7 may include a receive path. In this case, the radio-frequency signal S1 may be a frequency division duplex (FDD) signal and the radio-frequency signal S2 may be a time division duplex (TDD) signal. Conversely, the radio-frequency signal S1 may be the TDD signal and the radio-frequency signal S2 may be the FDD signal. Both of the radio-frequency signals S1 and S2 may be the TDD signals or the FDD signals.

### [1.2 Circuit configuration of power supply circuit 1]

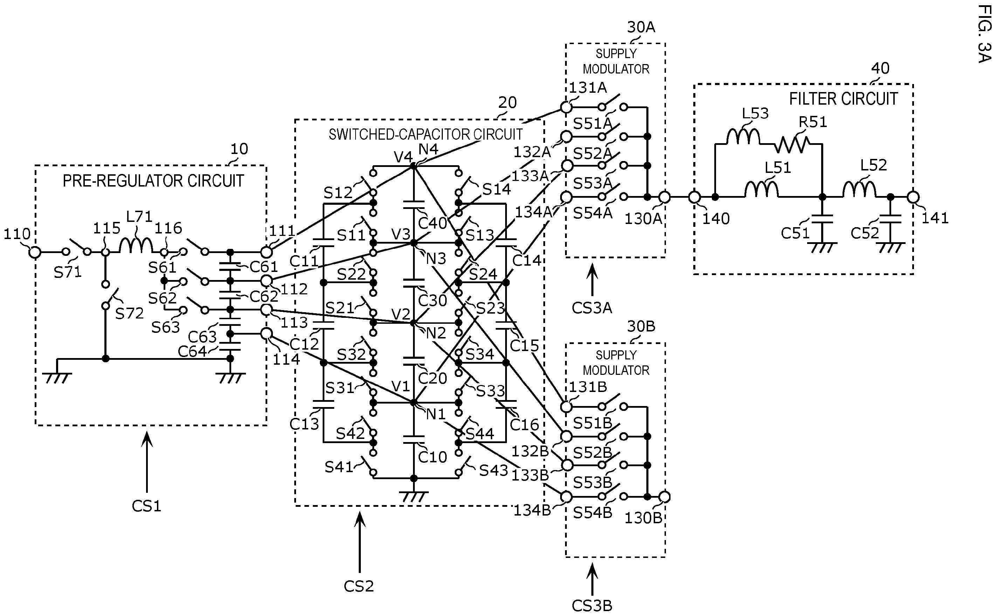

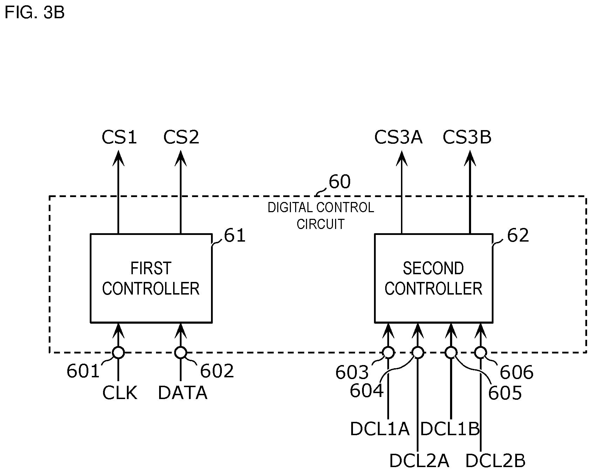

Next, the circuit configurations of the pre-regulator circuit 10, the switched-capacitor circuit 20, the supply modulators 30A and 30B, the filter circuit 40, and the digital control circuit 60, which are included in the power supply circuit 1, will be described with reference to Fig. 3A and Fig. 3B. Fig. 3A is a diagram illustrating the circuit configurations of the pre-regulator circuit 10, the switched-capacitor circuit 20, the supply modulators 30A and 30B, and the filter circuit 40 according to the present embodiment. Fig. 3B is a diagram illustrating the circuit configuration of the digital control circuit 60 according to the present embodiment.

Fig. 3A and Fig. 3B illustrate exemplary circuit configurations, and the pre-regulator circuit 10, the switched-capacitor circuit 20, the supply modulators 30A and 30B, the filter circuit 40, and the digital control circuit 60 can be mounted using any of a variety of circuit implementation and various circuit techniques. Accordingly, the following description of each circuit should not be limitedly interpreted.

### [1.2.1 Circuit configuration of switched-capacitor circuit 20]

First, the circuit configuration of the switched-capacitor circuit 20 will be described. The switched-capacitor circuit 20 includes capacitors C11 to C16, capacitors C10, C20, C30, and C40, and switches S11 to S14, S21 to S24, S31 to S34, and S41 to S44, as illustrated in Fig. 3A. Energy and electric charge are input from the pre-regulator circuit 10 into the switched-capacitor circuit 20 at nodes N1 to N4 and are supplied from the switched-capacitor circuit 20 to the supply modulators 30A and 30B at the nodes N1 to N4.

Each of the capacitors C11 to C16 functions as a flying capacitor (may be called a transfer capacitor). In other words, each of the capacitors C11 to C16 is used to step up or step down the first voltage supplied from the pre-regulator circuit 10. More specifically, the capacitors C11 to C16 move the electric charge between the capacitors C11 to C16 and the nodes N1 to N4 so that voltages V1 to V4 (voltages for ground potential) meeting V1:V2:V3:V4 = 1:2:3:4 are kept at the four nodes N1 to N4. The voltages V1 to V4 correspond to the multiple second voltages having the corresponding multiple discrete voltage levels.

The capacitor C11 has two electrodes. One of the two electrodes of the capacitor C11 is connected to one end of the switch S11 and one end of the switch S12. The other of the two electrodes of the capacitor C11 is connected to one end of the switch S21 and one end of the switch S22.

The capacitor C12 has two electrodes. One of the two electrodes of the capacitor C12 is connected to one end of the switch S21 and one end of the switch S22. The other of the two electrodes of the capacitor C12 is connected to one end of the switch S31 and one end of the switch S32.

The capacitor C13 has two electrodes. One of the two electrodes of the capacitor C13 is connected to one end of the switch S31 and one end of the switch S32. The other of the two electrodes of the capacitor C13 is connected to one end of the switch S41 and one end of the switch S42.

The capacitor C14 has two electrodes. One of the two electrodes of the capacitor C14 is connected to one end of the switch S13 and one end of the switch S14. The other of the two electrodes of the capacitor C14 is connected to one end of the switch S23 and one end of the switch S24.

The capacitor C15 has two electrodes. One of the two electrodes of the capacitor C15 is connected tone end of the switch S23 and one end of the switch S24. The other of the two electrodes of the capacitor C15 is connected to one end of the switch S33 and one end of the switch S34.

The capacitor C16 has two electrodes. One of the two electrodes of the capacitor C16 is connected to one end of the switch S33 and one end of the switch S34. The other of the two electrodes of the capacitor C16 is connected to one end of the switch S43 and one end of the switch S44.

Each of a set of the capacitors C11 and C14, a set of the capacitors C12 and C15, and a set of the capacitors C13 and C16 is capable of complementarily performing charge and discharge through repetition of a first phase and a second phase.

Specifically, in the first phase, the switches S12, S13, S22, S23, S32, S33, S42, and S43 are turned on. Accordingly, for example, one of the two electrodes of the capacitor C12 is connected to the node N3, the other of the two electrodes of the capacitor C12 and one of the two electrodes of the capacitor C15 are connected to the node N2, and the other of the two electrodes of the capacitor C15 is connected to the node N1.

In contrast, in the second phase, the switches S11, S14, S21, S24, S31, S34, S41, and S44 are turned on. Accordingly, for example, one of the two electrodes of the capacitor C15 is connected to the node N3, the other of the two electrodes of the capacitor C15 and one of the two electrodes of the capacitor C12 are connected to the node N2, and the other of the two electrodes of the capacitor C12 is connected to the node N1.

The repetition of the first phase and the second phase enables the other of the capacitors C12 and C15 to discharge into the capacitor C30 when one of the capacitors C12 and C15 is charged from the node N2. In other words, the capacitors C12 and capacitors C12 and C15 are capable of complementarily performing the charge and the discharge.

Each of the set of the capacitors C11 and C14 and the set of the capacitors C13 and C16 is capable of complementarily performing the charge and the discharge through repetition of the first phase and the second phase, like the set of the capacitors C12 and C15.

Each of the capacitors C10, C20, C30, and C40 functions a smoothing capacitor. In other words, each of the capacitors C10, C20, C30, and C40 is used to hold and smooth the voltages V1 to V4 at the nodes N1 to N4.

The capacitor C10 is connected between the node N1 and the ground. Specifically, one of the two electrodes of the capacitor C10 is connected to the node N1. The other of the two electrodes of the capacitor C10 is grounded.

The capacitor C20 is connected between the nodes N2 and N1. Specifically, one of the two electrodes of the capacitor C20 is connected to the node N2. The other of the two electrodes of the capacitor C20 is connected to the node N1.

The capacitor C30 is connected between the nodes N3 and N2. Specifically, one of the two electrodes of the capacitor C30 is connected to the node N3. The other of the two electrodes of the capacitor C30 is connected to the node N2.

The capacitor C40 is connected between the nodes N4 and N3. Specifically, one of the two electrodes of the capacitor C40 is connected to the node N4. The other of the two electrodes of the capacitor C40 is connected to the node N3.

The switch S11 is connected between one of the two electrodes of the capacitor C11 and the node N3. Specifically, one end of the switch S11 is connected to one of the two electrodes of the capacitor C11. The other end of the switch S11 is connected to the node N3.

The switch S12 is connected between one of the two electrodes of the capacitor C11 and the node N4. Specifically, one end of the switch S12 is connected to one of the two electrodes of the capacitor C11. The other end of the switch S12 is connected to the node N4.

The switch S21 is connected between one of the two electrodes of the capacitor C12 and the node N2. Specifically, one end of the switch S21 is connected to one of the two electrodes of the capacitor C12 and the other of the two electrodes of the capacitor C11. The other end of the switch S21 is connected to the node N2.

The switch S22 is connected between one of the two electrodes of the capacitor C12 and the node N3. Specifically, one end of the switch S22 is connected to one of the two electrodes of the capacitor C12 and the other of the two electrodes of the capacitor C11. The other end of the switch S22 is connected to the node N3.

The switch S31 is connected between the other of the two electrodes of capacitor C12 and the node N1. Specifically, one end of the switch S31 is connected to the other of the two electrodes of the capacitor C12 and one of the two electrodes of the capacitor C13. The other end of the switch S31 is connected to the node N1.

The switch S32 is connected between the other of the two electrodes of the capacitor C12 and the node N2. Specifically, one end of the switch S32 is connected to the other of the two electrodes of the capacitor C12 and one of the two electrodes of the capacitor C13. The other end of the switch S32 is connected to the node N2. In other words, the other end of the switch S32 is connected to the other end of the switch S21.

The switch S41 is connected between the other of the two electrodes of the capacitor C13 and the ground. Specifically, one end of the switch S41 is connected to the other of the two electrodes of the capacitor C13. The other end of the switch S41 is grounded.

The switch S42 is connected between the other of the two electrodes of the capacitor C13 and the node N1. Specifically, one end of the switch S42 is connected to the other of the two electrodes of the capacitor C13. The other end of the switch S42 is connected to the node N1. In other words, the other end of the switch S42 is connected to the other end of the switch S31.

The switch S13 is connected between one of the two electrodes of the capacitor C14 and the node N3. Specifically, one end of the switch S13 is connected to one of the two electrodes of the capacitor C14. The other end of the switch S13 is connected to the node N3. In other words, the other end of the switch S13 is connected to the other end of the switch S11 and the other end of the switch S22.

The switch S14 is connected between one of the two electrodes of the capacitor C14 and the node N4. Specifically, one end of the switch S14 is connected to one of the two electrodes of the capacitor C14. The other end of the switch S14 is connected to the node N4. In other words, the other end of the switch S14 is connected to the other end of the switch S12.

The switch S23 is connected between one of the two electrodes of the capacitor C15 and the node N2. Specifically, one end of the switch S23 is connected to one of the two electrodes of the capacitor C15 and the other of the two electrodes of the capacitor C14. The other end of the switch S23 is connected to the node N2. In other words, the other end of the switch S23 is connected to the other end of the switch S21 and the other end of the switch S32.

The switch S24 is connected between one of the two electrodes of the capacitor C15 and the node N3. Specifically, one end of the switch S24 is connected to one of the two electrodes of the capacitor C15 and the other of the two electrodes of the capacitor C14. The other end of the switch S24 is connected to the node N3. In other words, the other end of the switch S24 is connected to the other end of the switch S11, the other end of the switch S22, and the other end of the switch S13.

The switch S33 is connected between the other of the two electrodes of the capacitor C15 and the node N1. Specifically, one end of the switch S33 is connected to the other of the two electrodes of the capacitor C15 and one of the two electrodes of the capacitor C16. The other end of the switch S33 is connected to the node N1. In other words, the other end of the switch S33 is connected to the other end of the switch S31 and the other end of the switch S42.

The switch S34 is connected between the other of the two electrodes of the capacitor C15 and the node N2. Specifically, one end of the switch S34 is connected to the other of the two electrodes of the capacitor C15 and one of the two electrodes of the capacitor C16. The other end of the switch S34 is connected to the node N2. In other words, the other end of the switch S34 is connected to the other end of the switch S21, the other end of the switch S32, and the other end of the switch S23.

The switch S43 is connected between the other of the two electrodes of the capacitor C16 and the ground. Specifically, one end of the switch S43 is connected to the other of the two electrodes of the capacitor C16. The other end of the switch S43 is grounded.

The switch S44 is connected between the other of the two electrodes of the capacitor C16 and the node N1. Specifically, one end of the switch S44 is connected to the other of the two electrodes of the capacitor C16. The other end of the switch S44 is connected to the node N1. In other words, the other end of the switch S44 is connected to the other end of the switch S31, the other end of the switch S42, and the other end of the switch S33.

Turning-on and turning-off of a first set of switches including the switches S12, S13, S22, S23, S32, S33, S42, and S43 and a second set of switches including the switches S11, S14, S21, S24, S31, S34, S41, and S44 are complementarily switched. Specifically, the first set of switches is turned on and the second set of switches is turned off in the first phase. Conversely, the first set of switches is turned off and the second set of switches is turned on in the second phase.

For example, the charge from the capacitors C11 to C13 to the capacitors C10 to C40 is performed in one of the first phase and the second phase, and the charge from the capacitors C14 to C16 to the capacitors C10 to C40 is performed in the other of the first phase and the second phase. In other words, the capacitors C10 to C40 are constantly charged from the capacitors C11 to C13 or the capacitors C14 to C16. Accordingly, since the nodes N1 to N4 are charged at high speed even when current flows from the nodes N1 to N4 to the supply modulators 30A and 30B at high speed, variation in potential at the nodes N1 to N4 is capable of being suppressed.

Such an operation enables the switched-capacitor circuit 20 to keep approximately equal voltage at both ends of each of the capacitors C10, C20, C30, and C40. Specifically, the voltages V1 to V4 (the voltages for the ground potential) meeting V1:V2:V3:V4 = 1:2:3:4 are kept at the four nodes labeled with V1 to V4. The voltage levels of the voltages V1 to V4 correspond to the multiple discrete voltage levels that can be supplied to the supply modulators 30A and 30B by the switched-capacitor circuit 20.

The voltage ratio V1:V2:V3:V4 is not limited to 1:2:3:4. For example, the voltage ratio V1:V2:V3:V4 may be 1:2:4:8.

The configuration of the switched-capacitor circuit 20 illustrated in Fig. 3A is only an example and is not limited to this. Although the switched-capacitor circuit 20 is configured so as to be capable of supplying the voltages of the four discrete voltage levels in Fig. 3A, the switched-capacitor circuit 20 is not limited to this. The switched-capacitor circuit 20 may be configured so as to be capable of supplying the voltages of the discrete voltage levels of an arbitrary number that is two or more. For example, when the switched-capacitor circuit 20 supplies the voltages of the two discrete voltage levels, it is sufficient for the switched-capacitor circuit 20 to at least include the capacitors C12 and C15 and the switches S21 to S24 and S31 to S34.

### [1.2.2 Circuit configurations of supply modulators 30A and 30B]

Next, the circuit configurations of the supply modulators 30A and 30B will be described. The supply modulator 30A is an example of a first supply modulator and is connected to the digital control circuit 60. The supply modulator 30A includes input terminals 131A to 134A, switches S51A to S54A, and an output terminal 130A, as illustrated in Fig. 3A. The supply modulator 30B is an example of a second supply modulator and is connected to the digital control circuit 60. The supply modulator 30B includes input terminals 131B to 134B, switches S51B to S54B, and an output terminal 130B, as illustrated in Fig. 3A.

The supply modulator 30A is described below and a description of the supply modulator 30B is basically omitted. The supply modulator 30B is substantially the same as the supply modulator 30A in which "A" in the reference numerals and letters is replaced with "B" therein.

The output terminal 130A is connected to the filter circuit 40. The output terminal 130A is a terminal for supplying at least one voltage selected from the voltages V1 to V4 to the power amplifier 2A via the filter circuit 40 as the power supply voltage V_{ETA}. Since the supply modulator 30A can include various circuit elements and/or wirings that generate voltage drop, noise, and/or the like, as described above, the power supply voltage V_{ETA} observed at the output terminal 130A may include voltage different from the voltages V1 to V4.

The input terminals 131A to 134A are connected to the nodes N4 to N1, respectively, in the switched-capacitor circuit 20. The input terminals 131A to 134A are terminals for receiving the voltages V4 to V1, respectively, from the switched-capacitor circuit 20.

The switch S51A is connected between the input terminal 131A and the output terminal 130A. Specifically, the switch S51A has a terminal connected to the input terminal 131A and a terminal connected to the output terminal 130A. In this connection configuration, the switch S51A is capable of switching between connection and non-connection between the input terminal 131A and the output terminal 130A in response to switching between turning-on and turning-off with a control signal CS3A.

The switch S52A is connected between the input terminal 132A and the output terminal 130A. Specifically, the switch S52A has a terminal connected to the input terminal 132A and a terminal connected to the output terminal 130A. In this connection configuration, the switch S52A is capable of switching between connection and non-connection between the input terminal 132A and the output terminal 130A in response to switching between turning-on and turning-off with the control signal CS3A.

The switch S53A is connected between the input terminal 133A and the output terminal 130A. Specifically, the switch S53A has a terminal connected to the input terminal 133A and a terminal connected to the output terminal 130A. In this connection configuration, the switch S53A is capable of switching between connection and non-connection between the input terminal 133A and the output terminal 130A in response to switching between turning-on and turning-off with the control signal CS3A.

The switch S54A is connected between the input terminal 134A and the output terminal 130A. Specifically, the switch S54A has a terminal connected to the input terminal 134A and a terminal connected to the output terminal 130A. In this connection configuration, the switch S54A is capable of switching between connection and non-connection between the input terminal 134A and the output terminal 130A in response to switching between turning-on and turning-off with the control signal CS3A.

These switches S51A to S54A are controlled so as to be exclusively turned on. Specifically, only one of the switches S51A to S54A is turned on and the remaining switches of the switches S51A to S54A are turned off. With this configuration, the supply modulator 30A is capable of outputting one voltage selected from the voltages V1 to V4.

The configuration of the supply modulator 30A illustrated in Fig. 3A is only an example and is not limited to this. Particularly, it is sufficient for the switches S51A to S54A to select any one of the four input terminals 131A to 134A and connect the selected input terminal to the output terminal 130A and the switches S51A to S54A may have any configuration. For example, the supply modulator 30A may further include a switch connected between the switches S51A to S53A, and the switch S54A and the output terminal 130A. For example, the supply modulator 30A may further include a switch connected between the switches S51A and S52A, and the switches S53A and S54A and the output terminal 130A.

When the voltages of the two discrete voltage levels are supplied from the switched-capacitor circuit 20, it is sufficient for the supply modulator 30A to include at least two of the switches S51A to S54A.

### [1.2.3 Circuit configuration of pre-regulator circuit 10]

First, the configuration of the pre-regulator circuit 10 will be described. The pre-regulator circuit 10 includes an input terminal 110, output terminals 111 to 114, inductor connection terminals 115 and 116, switches S61 to S63, S71, and S72, a power inductor L71, and capacitors C61 to C64, as illustrated in Fig. 3A.

The input terminal 110 is the input terminal of the direct current voltage. In other words, the input terminal 110 is a terminal for receiving the input voltage from the direct current power source 50.

The output terminal 111 is the output terminal of the voltage V4. In other words, the output terminal 111 is a terminal for supplying the voltage V4 to the switched-capacitor circuit 20. The output terminal 111 is connected to the node N4 in the switched-capacitor circuit 20.

The output terminal 112 is the output terminal of the voltage V3. In other words, the output terminal 112 is a terminal for supplying the voltage V3 to the switched-capacitor circuit 20. The output terminal 112 is connected to the node N3 in the switched-capacitor circuit 20.

The output terminal 113 is the output terminal of the voltage V2. In other words, the output terminal 113 is a terminal for supplying the voltage V2 to the switched-capacitor circuit 20. The output terminal 113 is connected to the node N2 in the switched-capacitor circuit 20.

The output terminal 114 is the output terminal of the voltage V1. In other words, the output terminal 114 is a terminal for supplying the voltage V1 to the switched-capacitor circuit 20. The output terminal 114 is connected to the node N1 in the switched-capacitor circuit 20.

The inductor connection terminal 115 is connected to one end of the power inductor L71. The inductor connection terminal 116 is connected to the other end of the power inductor L71.

The switch S71 is connected between the input terminal 110 and one end of the power inductor L71. Specifically, the switch S71 has a terminal connected to the input terminal 110 and a terminal connected to one end of the power inductor L71 via the inductor connection terminal 115. In this connection configuration, the switch S71 is capable of switching between connection and non-connection between the input terminal 110 and one end of the power inductor L71 by switching between turning-on and turning-off.

The switch S72 is connected between one end of the power inductor L71 and the ground. Specifically, the switch S72 has a terminal connected to one end of the power inductor L71 via the inductor connection terminal 115 and a terminal that is grounded. In this connection configuration, the switch S72 is capable of switching between connection and non-connection between one end of the power inductor L71 and the ground by switching between turning-on and turning-off.

The switch S61 is connected between the other end of the power inductor L71 and the output terminal 111. Specifically, the switch S61 has a terminal connected to the other end of the power inductor L71 via the inductor connection terminal 116 and a terminal connected to the output terminal 111. In this connection configuration, the switch S61 is capable of switching between connection and non-connection between the other end of the power inductor L71 and the output terminal 111 by switching between turning-on and turning-off.

The switch S62 is connected between the other end of the power inductor L71 and the output terminal 112. Specifically, the switch S62 has a terminal connected to the other end of the power inductor L71 via the inductor connection terminal 116 and a terminal connected to the output terminal 112. In this connection configuration, the switch S62 is capable of switching between connection and non-connection between the other end of the power inductor L71 and the output terminal 112 by switching between turning-on and turning-off.

The switch S63 is connected between the other end of the power inductor L71 and the output terminal 113. Specifically, the switch S63 has a terminal connected to the other end of the power inductor L71 via the inductor connection terminal 116 and a terminal connected to the output terminal 113. In this connection configuration, the switch S63 is capable of switching between connection and non-connection between the other end of the power inductor L71 and the output terminal 113 by switching between turning-on and turning-off.

One of the two electrodes of the capacitor C61 is connected to the switch S61 and the output terminal 111. The other of the two electrodes of the capacitor C61 is connected to the switch S62, the output terminal 112, and one of the two electrodes of the capacitor C62.

One of the two electrodes of the capacitor C62 is connected to the switch S62, the output terminal 112, and the other of the two electrodes of the capacitor C61. The other of the two electrodes of the capacitor C62 is connected to a path with which the switch S63, the output terminal 113, and one of the two electrodes of the capacitor C63 are connected.

One of the two electrodes of the capacitor C63 is connected to the switch S63, the output terminal 113, and the other of the two electrodes of the capacitor C62. The other of the two electrodes of the capacitor C63 is connected to the output terminal 114 and one of the two electrodes of the capacitor C64.

One of the two electrodes of the capacitor C64 is connected to the output terminal 114 and the other of the two electrodes of the capacitor C63. The other of the two electrodes of the capacitor C64 is grounded.

The switches S61 to S63 are controlled so as to be exclusively turned on. Specifically, only one of the switches S61 to S63 is turned on and the remaining switches of the switches S61 to S63 are turned off. Turning on only one of the switches S61 to S63 enables the pre-regulator circuit 10 to vary the voltage to be supplied to the switched-capacitor circuit 20 between the voltage levels of the voltages V2 to V4.

The pre-regulator circuit 10 configured in the above manner is capable of supplying the electric charge to the switched-capacitor circuit 20 via at least one of the output terminals 111 to 113.

When the input voltage is converted into one first voltage, it is sufficient for the pre-regulator circuit 10 to at least include the switches S71 and S72 and the power inductor L71.

### [1.2.4 Circuit configuration of filter circuit 40]

Next, the circuit configuration of the filter circuit 40 will be described. The filter circuit 40 includes a low pass filter (LPF). Specifically, the filter circuit 40 includes inductors L51 to L53, capacitors C51 and C52, a resistor R51, an input terminal 140, and an output terminal 141, as illustrated in Fig. 3A.

The input terminal 140 is the input terminal of the voltage selected in the supply modulator 30A. In other words, the input terminal 140 is a terminal for receiving the voltage selected from the multiple voltages V1 to V4.

The output terminal 141 is an example of a first output terminal and is the output terminal of the power supply voltage V_{ETA}. In other words, the output terminal 141 is a terminal for supplying the power supply voltage V_{ETA} to the power amplifier 2A.

The inductors L51 to L53, the capacitors C51 and C52, and the resistor R51 compose a pulse shaping network. In the present embodiment, the pulse shaping network has a low-pass response. Accordingly, the filter circuit 40 is capable of reducing radio-frequency components included in the power supply voltage.

The configuration of the filter circuit 40 illustrated in Fig. 3A is only an example and is not limited to this. For example, the filter circuit 40 does not necessarily include the inductor L53 and the resistor R51. In addition, for example, the filter circuit 40 may include an inductor connected one of the two electrodes of the capacitor C51 and may include an inductor connected one of the two electrodes of the capacitor C52. The filter circuit 40 may be partially or completely composed of parasitic reactance and/or parasitic resistance. The parasitic reactance includes, for example, the inductance and/or the capacitance of metal trace with which two nodes are connected. The parasitic resistance includes, for example, the resistance of the metal trace with which two nodes are connected.

### [1.2.5 Circuit configuration of the digital control circuit 60]

Next, the circuit configuration of the digital control circuit 60 will be described. The digital control circuit 60 includes a first controller 61, a second controller 62, and control terminals 601 to 606, as illustrated in Fig. 3B.

The first controller 61 is capable of processing a source-synchronous digital control signal to generate control signals CS1 and CS2. The control signal CS1 is a signal for controlling tuning-on and turning-off of the switches S61 to S63, S71, and S72 included in the pre-regulator circuit 10. The control signal CS2 is a signal for controlling turning-on and turning-off of the switches S11 to S14, S21 to S24, S31 to S34, and S41 to S44 included in the switched-capacitor circuit 20. A feedback signal for controlling the switches S61 to S63, S71, and S72 in the pre-regulator circuit 10 is input into the first controller 61.

The digital control signal processed by the first controller 61 is not limited to the source-synchronous digital control signal. For example, the first controller 61 may process a clock-embedded digital control signal. The first controller 61 may generate a control signal for controlling the supply modulators 30A and 30B.

Although one set of a clock signal and a data signal is used as the digital control signals for the pre-regulator circuit 10 and the switched-capacitor circuit 20 in the present embodiment, the digital control signals for the pre-regulator circuit 10 and the switched-capacitor circuit 20 are not limited to this. For example, the sets of the clock signal and the data signal may be individually used as the digital control signals for the pre-regulator circuit 10 and the switched-capacitor circuit 20.

The second controller 62 processes digital control logic/line (DCL) signals (DCL1A and DCL2A) received from the RFIC 5A via the control terminals 603 and 604 to generate the control signal CS3A. The DCL signals (DCL1A and DCL2A) are generated by the RFIC 5A based on the envelope signal of the radio-frequency signal S1. The control signal CS3A is a signal for controlling turning-on and turning-off of the switches S51A to S54A included in the supply modulator 30A.

In addition, the second controller 62 processes DCL signals (DCL1B and DCL2B) received from the RFIC 5B via the control terminals 605 and 606 to generate a control signal CS3B. The DCL signals (DCL1B and DCL2B) are generated by the RFIC 5B based on the envelope signal of the radio-frequency signal S2. The control signal CS3B is a signal for controlling turning-on and turning-off of the switches S51B to S54B included in the supply modulator 30B.

Each of the DCL signals (DCL1A, DCL2A, DCL1B, and DCL2B) is a one-bit signal. Each of the voltages V1 to V4 is represented by a combination of two one-bit signals. For example, the V1, V2, V3, and V4 are represented by "00", "01" "10", and "11", respectively. Gray code may be used to represent the voltage levels.

Although the two digital control logic signals are used to control the supply modulator 30A and the two digital control logic signals are used to control the supply modulator 30B in the present embodiment, the number of the digital control logic signals is not limited to this. For example, the digital control logic signals of an arbitrary number that is one or three or more may be used depending on the number of the voltage levels which each of the supply modulators 30A and 30B can select. The digital control signals used to control the supply modulators 30A and 30B are not limited to the digital control logic signals.

### [1.3 Power supply voltage supplying method]

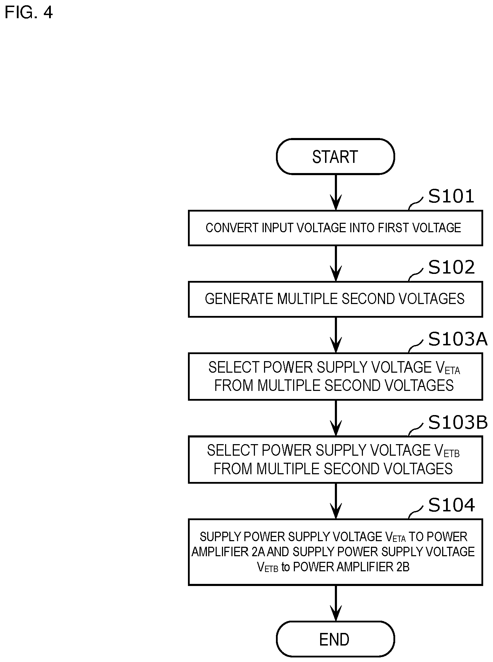

Next, a method of supplying the power supply voltage to the two power amplifiers 2A and 2B by the power supply circuit 1 configured in the above manner will be described with reference to Fig. 4. Fig. 4 is a flowchart illustrating a power supply voltage supplying method according to the present embodiment.

The pre-regulator circuit 10 converts the input voltage input from the direct current power source 50 into the first voltage (S101). The switched-capacitor circuit 20 generates the multiple second voltages having the corresponding multiple discrete voltage levels from the first voltage (S102). The supply modulator 30A selects at least one of the multiple second voltages as the power supply voltage V_{ETA} based on the envelope signal of the radio-frequency signal S1 (S103A). In other words, the supply modulator 30A controls the output voltage based on the envelope signal of the radio-frequency signal S1. The supply modulator 30B selects at least one of the multiple second voltages as the power supply voltage V_{ETB} based on the envelope signal of the radio-frequency signal S2 (S103B). In other words, the supply modulator 30B controls the output voltage based on the envelope signal of the radio-frequency signal S2. The power supply circuit 1 supplies the power supply voltage V_{ETA} selected by the supply modulator 30A to the power amplifier 2A and supplies the power supply voltage V_{ETB} selected by the supply modulator 30B to the power amplifier 2B (S104).

Part of the multiple steps may be omitted in Fig. 4. For example, Step S101 may be omitted. The order of the steps may be changed. For example, the order of Steps S103A and S103B may be reversed. Steps S103A and S103B may be concurrently performed.

An example of how to mount the communication device 7 configured in the above manner will now be described.

### [1.4 Arrangement of modules]

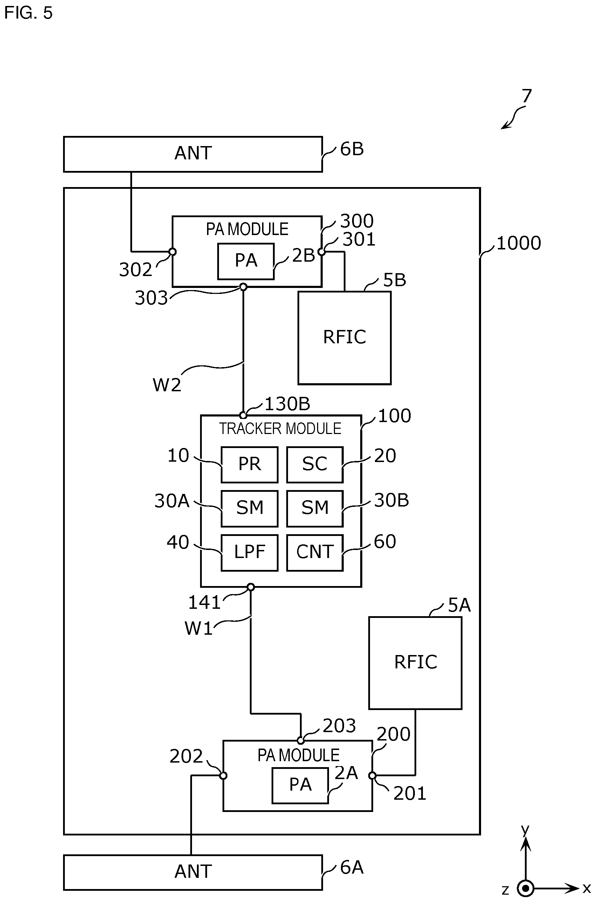

First, how a tracker module 100, power amplifier (PA) modules 200 and 300, and so on are arranged on a mother board 1000 of the communication device 7 will be described with reference to Fig. 5. Fig. 5 is a diagram illustrating how the modules are arranged on the mother board 1000 of the communication device 7 in the present embodiment.

The tracker module 100 is capable of supplying the power supply voltages V_{ETA} and V_{ETB} to the PA modules 200 and 300, respectively, and includes the pre-regulator circuit 10 (PR), the switched-capacitor circuit 20 (SC), the supply modulators 30A and 30B (SM), the filter circuit 40 (LPF), and the digital control circuit 60 (CNT). The tracker module 100 is arranged between the PA modules 200 and 300 on the mother board 1000.

The PA module 200 includes the power amplifier 2A (PA) capable of amplifying the cellular network Sub6 signal. The power supply terminal 203 of the PA module 200 is connected to the output terminal 141 of the tracker module 100 via wiring W1.

The PA module 300 includes the power amplifier 2B (PA) capable of amplifying the WLAN 2.4-GHz band signal. The power supply terminal 303 of the PA module 300 is connected to the output terminal 130B of the tracker module 100 via wiring W2. Here, the length of the wiring W2 may be shorter than the length of the wiring W1 and the width of the wiring W2 is may be wider than the width of the wiring W1.

The length of the wiring means the length along a direction in which current of a conductor electrically connecting two terminals flows. The width of the wiring means the length along a direction orthogonal the direction in which the current flows in a plan view of the board.

The RFIC 5A is arranged near the PA module 200. Specifically, the RFIC 5A is arranged closer to the PA module 200 than the PA module 300.

The RFIC 5B is arranged near the PA module 300. Specifically, the RFIC 5B is arranged closer to the PA module 300 than the PA module 200.

The antenna 6A is arranged at the side of a lower side of the mother board 1000 and is arranged near the PA module 200. The antenna 6B is arranged at the side of an upper side of the mother board 1000 and is arranged near the PA module 300.

### [1.5 Configuration of tracker module 100]

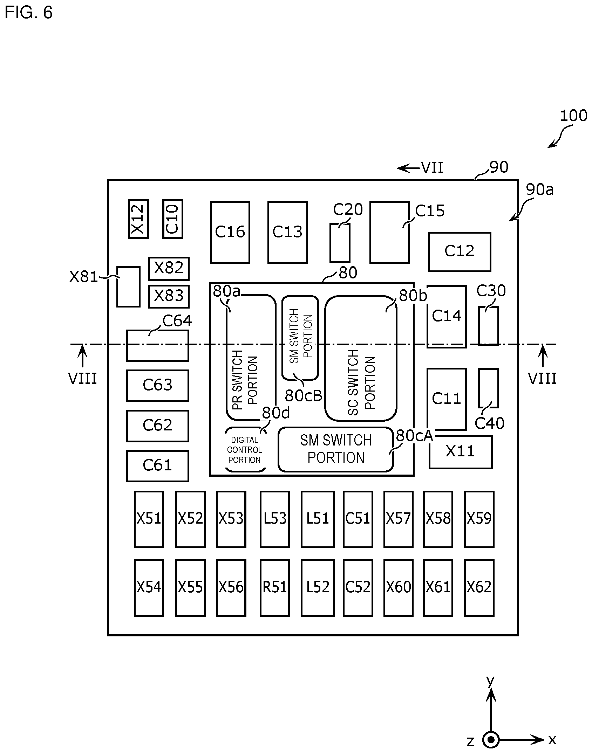

Next, the configuration of the tracker module 100 will be described with reference to Fig. 6 to Fig. 8. Although the power inductor L71 included in the pre-regulator circuit 10 is not arranged on a module laminate 90 and is not included in the tracker module 100 in the present embodiment, the power inductor L71 is not limited to this.

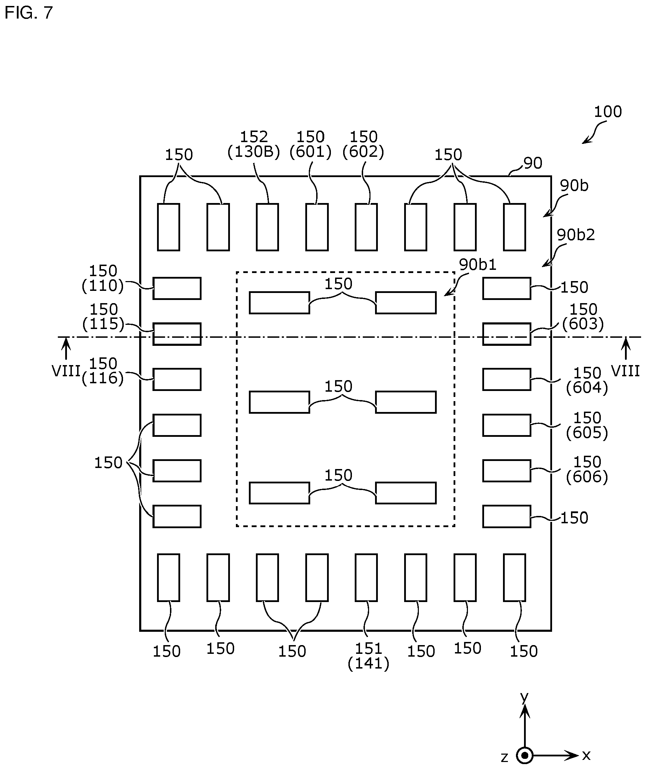

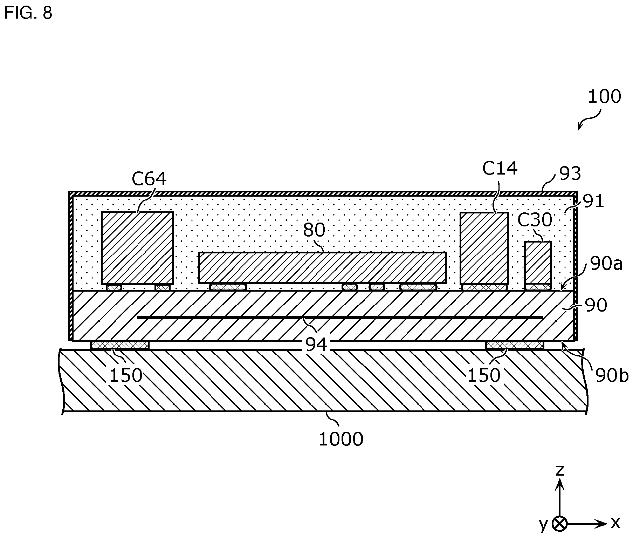

Fig. 6 is a plan view of the tracker module 100 according to the present embodiment. Fig. 7 is a plan view of the tracker module 100 according to the present embodiment and is a diagram when a main surface 90b side of the module laminate 90 is seen through from the positive side of the z axis. Fig. 8 is a cross-sectional view of the tracker module 100 according to the present embodiment. The cross section of the tracker module 100 in Fig. 8 is a cross section taken along the VIII-VIII line in Fig. 6 and Fig. 7.

Illustration of part of the wirings connecting multiple circuit components arranged on the module laminate 90 is omitted in Fig. 6 to Fig. 8. In addition, illustration of a resin member 91 covering the multiple circuit components and a shield electrode layer 93 covering the surfaces of the resin member 91 is omitted in Fig. 6 and Fig. 7.

The tracker module 100 includes the module laminate 90, the resin member 91, the shield electrode layer 93, circuit components X11, X12, X51 to X62, and X81 to X83, and multiple land electrodes 150, in addition to the multiple circuit components (excluding the power inductor L71) including active elements and passive elements, which are included in the pre-regulator circuit 10, the switched-capacitor circuit 20, the supply modulators 30A and 30B, the filter circuit 40, and the digital control circuit 60 illustrated in Fig. 3A and Fig. 3B.

The module laminate 90 has a main surface 90a and the main surface 90b, which are opposed to each other. Wiring layers, via conductors, a ground plane 94, and so on are formed in the module laminate 90. Although the module laminate 90 has a rectangular shape in a plan view in Fig. 6 and Fig. 7, the module laminate 90 is not limited to this shape.

Although, for example, a low temperature co-fired ceramics (LTCC) substrate or a high temperature co-fired ceramics (HTCC) substrate, which have a laminated structure of multiple dielectric layers, a component-embedded board, a substrate including a redistribution layer (RDL), or a printed circuit board is usable as the module laminate 90, the module laminate 90 is not limited to these.

An integrated circuit 80, the capacitors C10 to C16, C20, C30, C40, C51, C52, and C61 to C64, the inductors L51 to L53, the resistor R51, the circuit components X11, X12, X51 to X62, and X81 to X83, and the resin member 91 are arranged on the main surface 90a.

The integrated circuit 80 includes a PR switch portion 80a, an SC switch portion 80b, SM switch portions 80cA and 80cB, and a digital control portion 80d. The PR switch portion 80a includes the switches S61 to S63, S71, and S72. The SC switch portion 80b includes the switches S11 to S14, S21 to S24, S31 to S34, and S41 to S44. The SM switch portion 80cA includes the switches S51A to S54A. The SM switch portion 80cB includes the switches S51B to S54B. The digital control portion 80d includes the first controller 61 and the second controller 62.

Although the PR switch portion 80a, the SC switch portion 80b, the SM switch portions 80cA and 80cB, and the digital control portion 80d are included in one integrated circuit 80 in Fig. 6, the PR switch portion 80a, the SC switch portion 80b, the SM switch portions 80cA and 80cB, and the digital control portion 80d are not limited to this. For example, the PR switch portion 80a and the SC switch portion 80b may be included in one integrated circuit and the SM switch portions 80cA and 80cB may be included in another integrated circuit. For example, the SC switch portion 80b and the SM switch portions 80cA and 80cB may be included in one integrated circuit and the PR switch portion 80a may be included in another integrated circuit. The PR switch portion 80a and the SM switch portions 80cA and 80cB may be included in one integrated circuit and the SC switch portion 80b may be included in another integrated circuit. For example, the PR switch portion 80a, the SC switch portion 80b, and the SM switch portions 80cA and 80cB may be individually included in three integrated circuits. At this time, the digital control portion 80d may be included in each of the multiple integrated circuits or may be included in only one of the multiple integrated circuits. The multiple integrated circuits are capable of being manufactured at different process technology nodes.

Although the integrated circuit 80 has a rectangular shape in a plan view of the module laminate 90 in Fig. 6, the integrated circuit 80 is not limited to this shape.

The integrated circuit 80 is composed, for example, using complementary metal oxide semiconductor (CMOS) and, specifically, may be manufactured using a Silicon on Insulator (SOI) process. The integrated circuit 80 is not limited to the CMOS.

Each of the capacitors C10 to C16, C20, C30, C40, C51, C52, and C61 to C64 is mounted as a chip capacitor. The chip capacitor means a surface mount device (SMD) composing the capacitor. The mounting of the multiple capacitors is not limited to the chip capacitors. For example, part or all of the multiple capacitors may be included in an integrated passive device (IPD) or may be included in the integrated circuit 80.

Each of the inductor L51 to L53 is mounted as a chip inductor. The chip inductor means the SMD composing the inductor. The mounting of the multiple inductors is not limited to the chip inductors. For example, the multiple inductors may be included in the IPD.

The resistor R51 is mounted as a chip resistor. The chip resistor means the SMD composing the resistor. The mounting of the resistor R51 is not limited to the chip resistor. For example, the resistor R51 may be included in the IPD.

The multiple capacitors, the multiple inductors, and the resistor, which are arranged on the main surface 90a, are arranged around the integrated circuit 80 with being grouped for each circuit.

The group of the capacitors C61 to C64 included in the pre-regulator circuit 10 is arranged in an area on the main surface 90a, which is sandwiched between a straight line along the left side of the integrated circuit 80 and a straight line along the left side of the module laminate 90, in a plan view of the module laminate 90. Accordingly, the group of the circuit components included in the pre-regulator circuit 10 is arranged near the PR switch portion 80a in the integrated circuit 80.

The group of the capacitors C10 to C16, C20, C30, and C40 included in the switched-capacitor circuit 20 is arranged in an area on the main surface 90a, which is sandwiched between a straight line along the upper side of the integrated circuit 80 and a straight line along the upper side of the module laminate 90, and an area on the main surface 90a, which is sandwiched between a straight line along the right side of the integrated circuit 80 and a straight line along the right side of the module laminate 90, in a plan view of the module laminate 90. Accordingly, the group of the circuit components included in the switched-capacitor circuit 20 is arranged near the SC switch portion 80b in the integrated circuit 80. In other words, the SC switch portion 80b is arranged closer to the switched-capacitor circuit 20 than each of the PR switch portion 80a and the SM switch portion 80cA.

The group of the capacitors C51 and C52, the inductors L51 to L53, and the resistor R51 included in the filter circuit 40 is arranged in an area on the main surface 90a, which is sandwiched between a straight line along the lower side of the integrated circuit 80 and a straight line along the lower side of the module laminate 90, in a plan view of the module laminate 90. Accordingly, the group of the circuit components included in the filter circuit 40 is arranged near the SM switch portion 80cA in the integrated circuit 80. In other words, the SM switch portion 80cA is arranged closer to the filter circuit 40 than each of the PR switch portion 80a and the SC switch portion 80b.

The circuit components X11, X12, X51 to X62, and X81 to X83 are arbitrary circuit components, which are not essential to the present embodiment.

The resin member 91 covers at least part of multiple electronic components on the main surface 90a and the main surface 90a. The resin member 91 has a function to ensure the reliabilities, such as the mechanical strength and the moisture resistance, of the multiple electronic components on the main surface 90a. The resin member 91 is not necessarily included in the tracker module 100.

The multiple land electrodes 150 are arranged on the main surface 90b. The multiple land electrodes 150 function as multiple external connection terminals including ground terminals, in addition to the input terminal 110, the output terminals 130B and 141, the inductor connection terminals 115 and 116, and the control terminals 601 to 606 illustrated in Fig. 3A and Fig. 3B.

The multiple land electrodes 150 are electrically connected to input-output terminals, the ground terminals, and/or the likes on the mother board 1000 arranged in the negative direction of the z axis of the tracker module 100. In addition, the multiple land electrodes 150 are electrically connected to the multiple circuit components arranged on the main surface 90a via the via conductors and so on formed in the module laminate 90.

Although copper electrodes may be used as the multiple land electrodes 150, the land electrodes 150 are not limited to this. For example, solder electrodes may be used as the multiple land electrodes 150. Alternatively, multiple bump electrodes or multiple post electrodes may be used as the multiple external connection terminals, instead of the multiple land electrodes 150.

Referring to Fig. 7, the multiple land electrodes 150 include the 28 land electrodes 150 arranged in an outer peripheral area 90b2 surrounding a central area 90b1 of the module laminate 90 and the six land electrodes 150 arranged in the central area 90b1 of the module laminate 90, in a plan view of the module laminate 90. The 28 land electrodes 150 arranged in the outer peripheral area 90b2 include a land electrode 151 functioning as the output terminal 141 and a land electrode 152 functioning as the output terminal 130B. The land electrodes 151 and 152 are arranged along sides that are opposed to each other in a plan view of the module laminate 90. Referring to Fig. 7, the land electrode 151 is arranged along the lower side (an example of a first side) of the module laminate 90 and the land electrode 152 is arranged along the upper side (an example of a second side) of the module laminate 90. In other words, the land electrode 151 is arranged in an area along the lower side of the module laminate 90, in the outer peripheral area 90b2, and the land electrode 152 is arranged in an area along the upper side of the module laminate 90, in the outer peripheral area 90b2.

The shield electrode layer 93 is a metal thin film formed using, for example, a sputtering method. The shield electrode layer 93 is formed so as to cover the surfaces (the upper face and the side faces) of the resin member 91. The shield electrode layer 93 is grounded to suppress intrusion of external noise into the electronic components composing the tracker module 100 and interference of noise occurring at the tracker module 100 in other modules and other devices. The shield electrode layer 93 is not necessarily included in the tracker module 100.

The configuration of the tracker module 100 according to the present embodiment is only an example and is not limited to this. For example, part of the capacitors and the inductors arranged on the main surface 90a may be formed in the module laminate 90. Part of the capacitors and the inductors arranged on the main surface 90a is not necessarily included in the tracker module 100 and is not necessarily arranged in or on the module laminate 90.

The positional relationship between the land electrode 151 functioning as the output terminal 141 and the land electrode 152 functioning as the output terminal 130B is only an example and may be arbitrarily changed depending on the positional relationship with the tracker module 100 and the PA modules 200 and 300. For example, the land electrodes 151 and 152 may be arranged along the same side. For example, the land electrodes 151 and 152 may be individually arranged along two sides that are orthogonal to each other.

### [1.6 Configuration of PA modules 200 and 300]

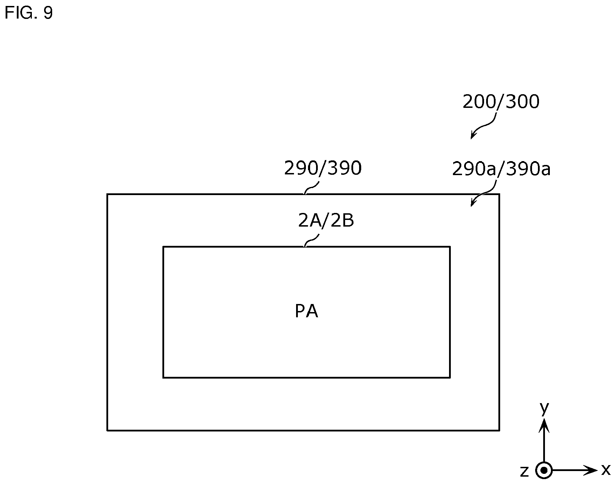

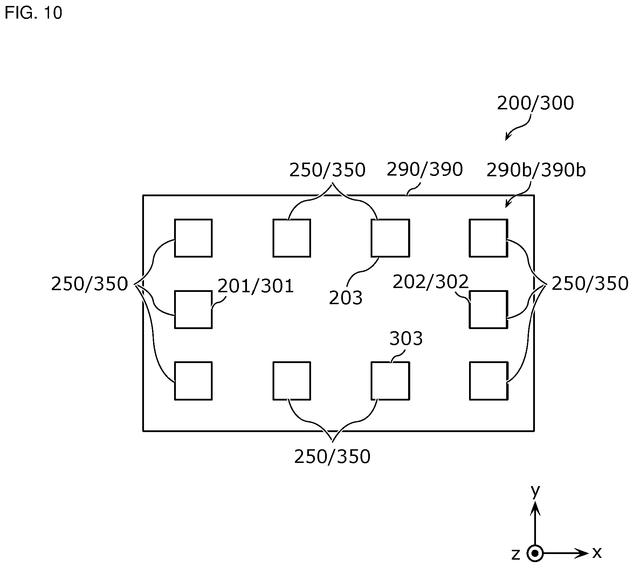

Next, the configuration of the PA modules 200 and 300 will be described with reference to Fig. 9 and Fig. 10. Since the PA modules 200 and 300 have similar components, a description of the PA module 300 is omitted for the same components.

Fig. 9 is a plan view of the PA modules 200 and 300 according to the present embodiment. Fig. 10 is a plan view of the PA modules 200 and 300 according to the present embodiment and is a diagram when main surfaces 290b and 390b sides of module laminates 290 and 390 are seen through from the positive side of the z axis.

Illustration of wirings connecting the multiple circuit components arranged on the module laminates 290 and 390 is omitted in Fig. 9 and Fig. 10. Illustration of the resin member covering the multiple circuit components and the shield electrode layer covering the surfaces of the resin member is omitted in Fig. 9 and Fig. 10.

The PA module 200 includes the module laminate 290 and multiple land electrodes 250, in addition to the power amplifier 2A.

The module laminate 290 has a main surface 290a and the main surface 290b, which are opposed to each other. Wiring layers, via conductors, the ground plane, and so on are formed in the module laminate 290. Although the module laminate 290 has a rectangular shape in a plan view in Fig. 9 and Fig. 10, the module laminate 290 is not limited to this shape.

Although, for example, an LTCC substrate or an HTCC substrate, which have a laminated structure of multiple dielectric layers, a component-embedded board, a substrate including an RDL, or a printed circuit board is usable as the module laminate 290, the module laminate 290 is not limited to these.

The power amplifier 2A is arranged on the main surface 290a. The power amplifier 2A is mounted in, for example, an integrated circuit. Although the integrated circuit is made of at least one of silicon (Si), gallium arsenide (GaAs), silicon germanium (SiGe), and gallium nitride (GaN), the material of the integrated circuit is not limited to the above materials.

The multiple land electrodes 250 are arranged on the main surface 90b. The multiple land electrodes 250 function as the multiple external connection terminals including the ground terminals, in addition to the input terminal 201, the output terminal 202, and the power supply terminal 203 illustrated in Fig. 5.

The multiple land electrodes 250 are electrically connected to the input-output terminals, the ground terminals, and/or the likes on the mother board 1000 arranged in the negative direction of the z axis of the PA module 200. In addition, the multiple land electrodes 250 are electrically connected to the power amplifier 2A arranged on the main surface 290a via the via conductors and so on formed in the module laminate 290.

Although copper electrodes may be used as the multiple land electrodes 250, the land electrodes 250 are not limited to this. For example, solder electrodes may be used as the multiple land electrodes 250. Alternatively, multiple bump electrodes or multiple post electrodes may be used as the multiple external connection terminals, instead of the multiple land electrodes 250.

The configuration of the PA modules 200 and 300 according to the present embodiment is only an example and is not limited to this.

### [1.7 Advantages and so on]

As described above, the power supply circuit 1 according to the present embodiment includes the switched-capacitor circuit 20 that generates the multiple second voltages having the corresponding multiple discrete voltage levels from the first voltage, the supply modulator 30A that selects at least one of the multiple second voltages as the power supply voltage V_{ETA} based on the envelope signal of the radio-frequency signal S1 and supplies the selected power supply voltage V_{ETA} to the power amplifier 2A, which is capable of amplifying the radio-frequency signal S1, and the supply modulator 30B that selects at least one of the multiple second voltages as the power supply voltage V_{ETB} based on the envelope signal of the radio-frequency signal S2 and supplies the selected power supply voltage V_{ETB} to the power amplifier 2B, which is capable of amplifying the radio-frequency signal S2. The radio-frequency signal S1 is the cellular network Sub6 signal and the radio-frequency signal S2 is the WLAN 2.4-GHz band signal.

With the above configuration, the second voltage selected from the multiple second voltages having the corresponding multiple discrete voltage levels based on the envelope signal of the WLAN signal is supplied to the power amplifier 2B as the power supply voltage V_{ETB}. Since the band width of the WLAN signal is generally wide, the change ratio of variation in amplitude of the envelope signal is high (that is, the envelope signal is rapidly changed). Accordingly, it is difficult to use the analog ET mode to amplify the WLAN signal and the APT mode or a fixed voltage mode is frequently used. Use of the digital ET mode for the amplification of the WLAN signal enables the PAE to be improved. In addition, according to the present embodiment, the digital ET mode is applied to both the power amplifier 2A amplifying the cellular network signal and the power amplifier 2B amplifying the WLAN signal. Accordingly, the switched-capacitor circuit 20 generating the multiple second voltages is capable of being shared between the power amplifiers 2A and 2B to contribute to reduction in size of the power supply circuit 1 (reduction in the area occupied by the power supply circuit 1), compared with a case in which the analog ET mode requiring a voltage generator for each power amplifier is applied to the power amplifiers 2A and 2B.

For example, the power supply circuit 1 according to the present embodiment may further include the module laminate 90 on which the switched-capacitor circuit 20 and the supply modulators 30A and 30B are mounted, the output terminal 141 through which the power supply voltage V_{ETA} is supplied to the power amplifier 2A, and the output terminal 130B through which the power supply voltage V_{ETB} is supplied to the power amplifier 2B. The output terminal 141 may be arranged along the lower side of the module laminate 90 and the output terminal 130B may be arranged along the upper side of the module laminate 90.

With the above configuration, the output terminals 141 and 130B connected to the two power amplifiers 2A and 2B, respectively, are arranged along the sides of the module laminate 90, which are opposed to each other. Accordingly, it is possible to increase the degree of freedom of the arrangement of the power amplifiers 2A and 2B and the power supply circuit 1 to easily shorten the wiring lengths for connecting the power amplifiers 2A and 2B to the power supply circuit 1.

For example, the power supply circuit 1 according to the present embodiment may be arranged between the power amplifiers 2A and 2B.

With the above configuration, it is possible to shorten the wiring lengths for connecting the output terminals 141 and 130B to the power amplifiers 2A and 2B, respectively, to suppress degradation of the power supply voltage signal due to parasitic capacitance and/or parasitic inductance.

For example, the power supply circuit 1 according to the present embodiment may further include the module laminate 90 on which the switched-capacitor circuit 20 and the supply modulators 30A and 30B are mounted, the output terminal 141 through which the power supply voltage V_{ETA} is supplied to the power amplifier 2A, and the output terminal 130B through which the power supply voltage V_{ETB} is supplied to the power amplifier 2B. The output terminals 141 and 130B may be arranged along the same side of the module laminate 90.

With the above configuration, the wiring lengths for connecting the power supply circuit 1 to the respective power amplifiers 2A and 2B are easily shortened, for example, in a case in which the power amplifiers 2A and 2B are arranged in similar directions with respect to the module laminate 90.

For example, in the power supply circuit 1 according to the present embodiment, the radio-frequency signal S1 may be an FDD transmission signal. The power supply circuit 1 may further include the filter circuit 40 connected to the supply modulator 30A. The supply modulator 30A may supply the power supply voltage V_{ETA} to the power amplifier 2A via the filter circuit 40.

With the above configuration, since the power supply voltage V_{ETA} is supplied to the power amplifier 2A via the filter circuit 40, it is possible to suppress reduction in the receiving sensibility of an FDD reception signal due to noise included in the signal of the power supply voltage V_{ETA}.

For example, in the power supply circuit 1 according to the present embodiment, the filter circuit 40 may be mounted on the module laminate 90.

With the above configuration, it is possible to contribute to reduction in size of the communication device 7.

For example, the power supply circuit 1 according to the present embodiment may further include the pre-regulator circuit 10 that converts the input voltage into the first voltage using the power inductor L71.

With the above configuration, it is possible to suppress variation in the first voltage due to variation in voltage of the direct current power source 50 to improve the stability of the voltage levels of the multiple second voltages generated in the switched-capacitor circuit 20.

The power supply voltage supplying method according to the present embodiment includes generating the multiple second voltages having the corresponding multiple discrete voltage levels from the first voltage, selecting at least one of the generated multiple second voltages as the power supply voltage V_{ETA} based on the envelope signal of the radio-frequency signal S1, supplying the selected power supply voltage V_{ETA} to the power amplifier 2A capable of amplifying the radio-frequency signal S1, selecting at least one of the multiple second voltages as the power supply voltage V_{ETB} based on the envelope signal of the radio-frequency signal S2, and supplying the selected power supply voltage V_{ETB} to the power amplifier 2B capable of amplifying the radio-frequency signal S2. The radio-frequency signal S1 is the cellular network signal and the radio-frequency signal S2 is the WLAN signal.

With the above method, it is possible to achieve the same advantages as those of the power supply circuit 1.

For example, the power supply voltage supplying method according to the present embodiment may further include generating the first DCL signals (DCL1A and DCL2A) based on the envelope signal of the radio-frequency signal S1, generating the second DCL signals (DCL1B and DCL2B) based on the envelope signal of the radio-frequency signal S2, selecting the power supply voltage V_{ETA} based on the first DCL signals, and selecting the power supply voltage V_{ETB} based on the second DCL signals.

With the above method, it is possible to select the power supply voltages from the multiple second voltages based on the DCL signals generated based on the envelope signal.

Although the WLAN 2.4-GHz band signal is used as the radio-frequency signal S2 in the present embodiment, the radio-frequency signal S2 is not limited to this. For example, the WLAN 5-GHz band signal may be used as the radio-frequency signal S2.

### (Second embodiment)

Next, a second embodiment will be described. The present embodiment mainly differs from the first embodiment in that the power amplifier 2B is capable of amplifying the WLAN 5-GHz band signal and in that the supply modulator 30B is not included in the tracker module but is included in an SW module. The following description of the present embodiment focuses on points different from the first embodiment.

Since the circuit configurations of the communication device 7 and the power supply circuit 1 and the power supply voltage supplying method according to the present embodiment are the same as those in the first embodiment, a description of the circuit configurations of the communication device 7 and the power supply circuit 1 and the power supply voltage supplying method according to the present embodiment is omitted herein.

### [2.1 Arrangement of modules]

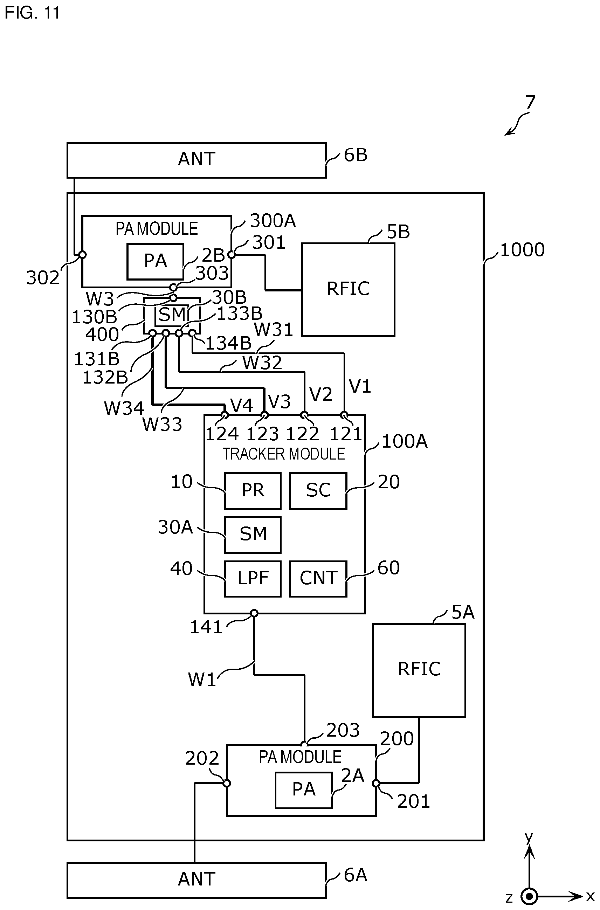

How a tracker module 100A, the PA module 200, a PA module 300A, the integrated circuit 400, and so on are arranged on the mother board 1000 of the communication device 7 will be described with reference to Fig. 11. Fig. 11 is a diagram illustrating how the modules are arranged on the mother board 1000 in the present embodiment.

The tracker module 100A includes the pre-regulator circuit 10 (PR), the switched-capacitor circuit 20 (SC), the supply modulator 30A (SM), the filter circuit 40 (LPF), and the digital control circuit 60 (CNT). The tracker module 100A is arranged between the PA modules 200 and 300A on the mother board 1000. The tracker module 100A has output terminals 121 to 124 that are connected to the nodes N1 to N4, respectively, in the switched-capacitor circuit 20 and that supply the voltages V1 to V4, respectively. With this configuration, the tracker module 100A is capable of supplying the power supply voltage V_{ETA} to the PA module 200 via the output terminal 141 and capable of applying the multiple voltages V1 to V4 to the integrated circuit 400 via the output terminals 121 to 124 (not via the supply modulator).

In the tracker module 100A, the module laminate 90 is an example of a first substrate, the output terminal 141 is an example of the first output terminal, and the output terminals 121 to 124 are an example of multiple second output terminals.

The PA module 300A includes the power amplifier 2B (PA) capable of amplifying the WLAN 5-GHz band signal. The power supply terminal 303 of the PA module 300A is connected to the output terminal 130B of the integrated circuit 400 via wiring W3. With this configuration, the PA module 300A is capable of receiving the power supply voltage V_{ETB} from the integrated circuit 400.

The integrated circuit 400 includes the supply modulator 30B and is arranged between the tracker module 100A and the PA module 300A on the mother board 1000. The integrated circuit 400 is an integrated circuit composed, for example, using the CMOS and is arranged on the mother board 1000. In the present embodiment, the mother board 1000 is an example of a second substrate. The integrated circuit 400 may be manufactured, for example, using the SOI process. The integrated circuit 400 is not limited to the CMOS.

The integrated circuit 400 is connected to the tracker module 100A via wirings W31 to W34. In the integrated circuit 400, the input terminals 131B to 134B are an example of multiple first input terminals. Specifically, the input terminal 131B is connected to the output terminal 124 of the tracker module 100A via the wiring W34. The input terminal 132B is connected to the output terminal 123 of the tracker module 100A via the wiring W33. The input terminal 133B is connected to the output terminal 122 of the tracker module 100A via the wiring W32. The input terminal 134B is connected to the output terminal 121 of the tracker module 100A via the wiring W31. With this configuration, the voltages V4 to V1 are supplied from the switched-capacitor circuit 20 to the input terminals 131B to 134B, respectively. The length of the wiring W34 may be shorter than the length of the wiring W31 and the width of the wiring W34 may be wider than the width of the wiring W31.

### [2.2 Circuit of tracker module 100A]

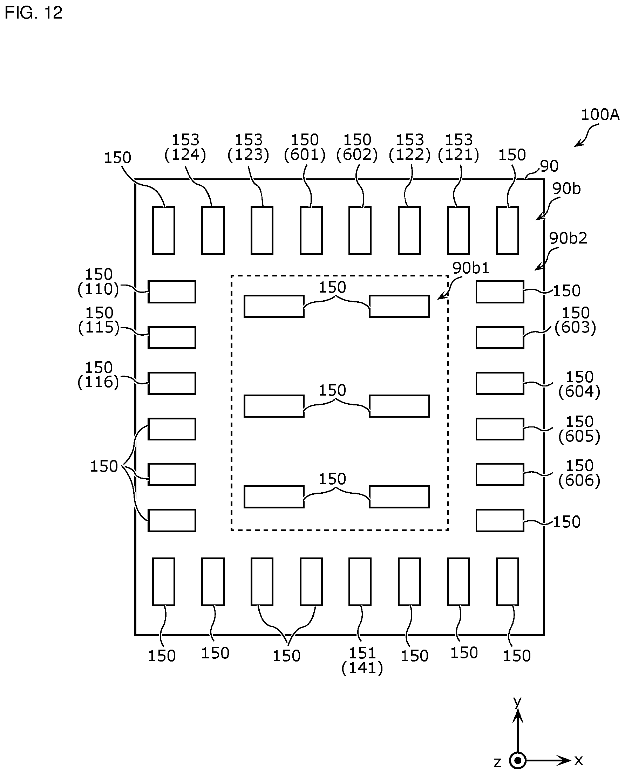

Next, the configuration of the tracker module 100A will be described with reference to Fig. 12. How the multiple land electrodes 150 are arranged on the main surface 90b of the module laminate 90 will be described with reference to Fig. 12 here.

Fig. 12 is a plan view of the tracker module 100A according to the present embodiment and is a diagram when the main surface 90b side of the module laminate 90 is seen through from the positive side of the z axis. The multiple land electrodes 150 are arranged on the main surface 90b. The multiple land electrodes 150 function as the multiple external connection terminals including the ground terminals, in addition to the input terminal 110, the output terminals 121 to 124 and 141, the inductor connection terminals 115 and 116, and the control terminals 601 to 606.

Referring to Fig. 12, the land electrodes 150 include the 28 land electrodes 150 arranged in the outer peripheral area 90b2 surrounding the central area 90b1 of the module laminate 90 and the six land electrodes 150 arranged in the central area 90b1 of the module laminate 90, in a plan view of the module laminate 90. The 28 land electrodes 150 arranged in the outer peripheral area 90b2 include the land electrode 151 functioning as the output terminal 141 and four land electrodes 153 functioning as the output terminals 121 to 124. The land electrodes 151 and 153 are arranged along sides that are opposed to each other in a plan view of the module laminate 90. Referring to Fig. 12, the land electrode 151 is arranged along the lower side of the module laminate 90 and the land electrodes 153 are arranged along the upper side of the module laminate 90. In other words, the land electrode 151 is arranged in an area along the lower side of the module laminate 90, in the outer peripheral area 90b2, and the land electrodes 153 are arranged in areas along the upper side of the module laminate 90, in the outer peripheral area 90b2.

The configuration of the tracker module 100A according to the present embodiment is only an example and is not limited to this. The positional relationship between the land electrode 151 functioning as the output terminal 141 and the land electrodes 153 functioning as the output terminals 121 to 124 is only an example and may be arbitrarily changed depending on the positional relationship with the tracker module 100A and the PA modules 200 and 300A. For example, the land electrodes 151 and 153 may be arranged along the same side. For example, the land electrodes 151 and 153 may be individually arranged along two sides that are orthogonal to each other.

### [2.3 Advantages and so on]

As described above, the tracker module 100A according to the present embodiment includes the module laminate 90, the integrated circuit 80 arranged on the module laminate 90, and the output terminal 141 that is capable of being externally connected and the multiple output terminals 121 to 124. The integrated circuit 80 includes at least one switch included in the switched-capacitor circuit 20 and at least one switch included in the supply modulator 30A. The switched-capacitor circuit 20 is configured so as to generate the multiple discrete voltages based on the input voltage and to supply the generated multiple discrete voltages to the supply modulator 30A and the multiple output terminals 121 to 124. The supply modulator 30A is configured so as to selectively supply at least one of the multiple discrete voltages generated by the switched-capacitor circuit 20 to the output terminal 141.

With the above configuration, the tracker module 100A is capable of outputting the multiple discrete voltages from the switched-capacitor circuit 20 via the multiple output terminals 121 to 124. Accordingly, it is not necessary to include the supply modulator 30B connected between the switched-capacitor circuit 20 and the power amplifier 2B in the tracker module 100A and, thus, the supply modulator 30B is capable of being kept apart from the switched-capacitor circuit 20. As a result, the supply modulator 30B is capable of being arranged so as to be closer to the power amplifier 2B to shorten the length of the wiring W3 with which the supply modulator 30B is connected to the power amplifier 2B. This reduces the parasitic capacitance, the parasitic inductance, and/or the like of the wiring W3 to suppress the degradation of the power supply voltage V_{ETB}. In addition, according to the present embodiment, the switched-capacitor circuit 20 is capable of being shared between the multiple power amplifiers 2A and 2B to reduce the size of the tracker module 100A, compared with the case in which the analog ET mode requiring the voltage generator for each power amplifier is used.

For example, in the tracker module 100A according to the present embodiment, the supply modulator 30A may be configured so as to control the output voltage based on the envelope signal of the radio-frequency signal S1.

With the above configuration, it is possible to apply the digital ET mode to the power amplifier 2A to improve the PAE.

For example, in the tracker module 100A according to the present embodiment, the module laminate 90 may have the lower side and the upper side that are opposed to each other. The output terminal 141 may be arranged along the lower side and the multiple output terminals 121 to 124 may be arranged along the upper side.

With the above configuration, the output terminal 141 and the output terminals 121 to 124 are arranged along the sides of the module laminate 90, which are opposed to each other. Accordingly, it is possible to improve the degree of freedom of the arrangement of the PA module 200 connected to the output terminal 141 and the PA module 300A connected to the output terminals 121 to 124 to easily shorten the wiring lengths for connecting the PA module 200 and 300A to the tracker module 100A.

For example, in the tracker module 100A according to the present embodiment, the output terminal 141 may be connected to the power amplifier 2A configured so as to amplify the cellular network Sub6 signal or the WLAN 2.4-GHz band signal (the radio-frequency signal S1). The multiple output terminals 121 to 124 may be connected to the power amplifier 2B configured so as to amplify the WLAN 5-GHz band signal (the radio-frequency signal S2).

With the above configuration, shortening the wiring W3 with which the supply modulator 30B is connected to the power amplifier 2B capable of amplifying the WLAN 5-GHz band signal enables the parasitic capacitance, the parasitic inductance, and/or the like of the wiring W3 to be reduced to suppress the degradation of the power supply voltage V_{ETB}. In particular, since a wider channel band width can be used for the WLAN 5-GHz band signal, the variation with time of the power supply voltage V_{ETB} is increased. Accordingly, the reduction in the parasitic capacitance and/or the parasitic inductance of the wiring W3 has a large effect of suppressing the degradation of the power supply voltage V_{ETB}.

In the present embodiment, the power amplifier 2A and the antenna 6A are not necessarily included in the communication device 7. In this case, the supply modulator 30A and the filter circuit 40 are not necessarily included in the power supply circuit 1.

### (Third embodiment)

Next, a third embodiment will be described. The present embodiment mainly differs from the first and second embodiments in that the power amplifier 2B is capable of amplifying the cellular network millimeter-wave signal and in that the supply modulator 30B is included in a PA module. The following description of the present embodiment focuses on points different from the first and second embodiments.

Since the circuit configurations of the communication device 7 and the power supply circuit 1 and the power supply voltage supplying method according to the present embodiment are the same as those in the first embodiment, a description of the circuit configurations of the communication device 7 and the power supply circuit 1 and the power supply voltage supplying method according to the present embodiment is omitted herein.

### [3.1 Arrangement of modules]

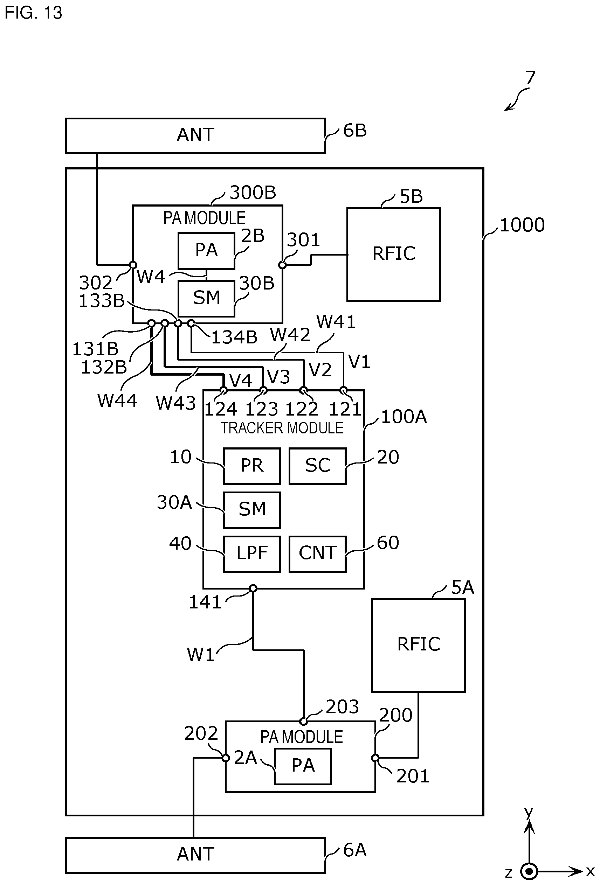

How the tracker module 100A, the PA module 200, a PA module 300B, and so on are arranged on the mother board 1000 of the communication device 7 will be described with reference to Fig. 13. Fig. 13 is a diagram illustrating how the modules are arranged on the mother board 1000 in the present embodiment.

The PA module 300B includes the power amplifier 2B (PA) capable of amplifying the cellular network millimeter-wave signal and the supply modulator 30B (SM). In the present embodiment, the power amplifier 2B in the PA module 300B is an example of the second power amplifier. In the PA module 300B, the power amplifier 2B is connected to the supply modulator 30B via wiring W4. The length of the wiring W4 may be shorter than the length of the wiring W1 and the width of the wiring W4 may be wider than the width of the wiring W1.

The PA module 300B has the input terminals 131B to 134B. In the present embodiment, the input terminals 131B to 134B of the PA module 300B are examples of the multiple first input terminals. The input terminals 131B to 134B are connected to the tracker module 100A via wirings W44 to W41. Specifically, the input terminal 131B is connected to the output terminal 124 of the tracker module 100A via the wiring W44. The input terminal 132B is connected to the output terminal 123 of the tracker module 100A via the wiring W43. The input terminal 133B is connected to the output terminal 122 of the tracker module 100A via the wiring W42. The input terminal 134B is connected to the output terminal 121 of the tracker module 100A via the wiring W41. With this configuration, the voltages V4 to V1 are applied from the switched-capacitor circuit 20 to the input terminals 131B to 134B, respectively. The length of the wiring W44 may be shorter than the length of the wiring W41 and the width of the wiring W44 may be wider than the width of the wiring W41.

### [3.2 Configuration of PA module 300B]

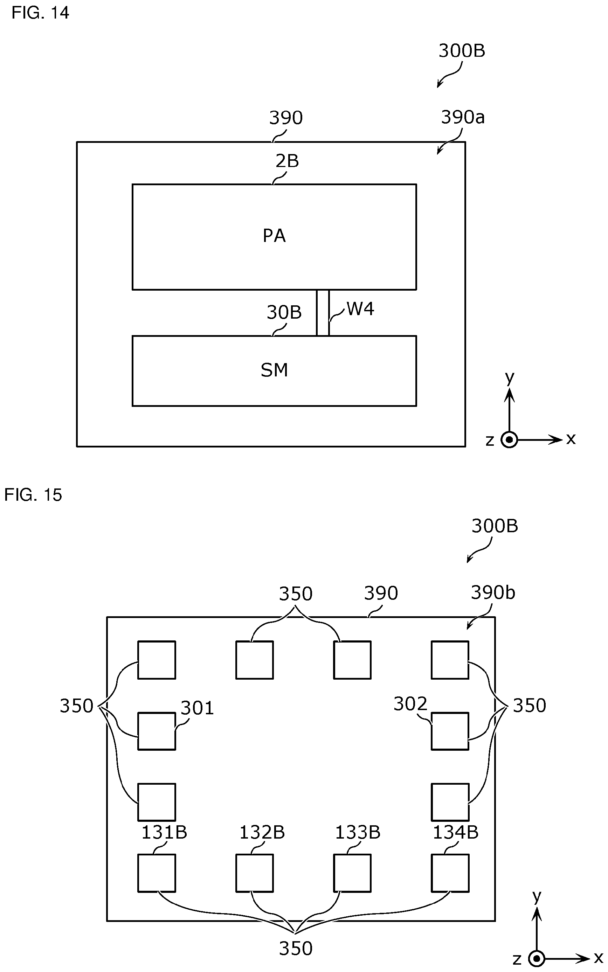

Next, the configuration of the PA module 300B will be described with reference to Fig. 14 and Fig. 15. Fig. 14 is a plan view of the PA module 300B according to the present embodiment. Fig. 15 is a plan view of the PA module 300B according to the present embodiment and is a diagram when the main surface 390b side of the module laminate 390 are seen through from the positive side of the z axis.

Illustration of part of wirings connecting the multiple circuit components arranged on the module laminate 390 is omitted in Fig. 14 and Fig. 15. Illustration of the resin member covering the multiple circuit components and the shield electrode layer covering the surfaces of the resin member is omitted in Fig. 14 and Fig. 15.

The PA module 300B includes the module laminate 390 and multiple land electrodes 350, in addition to the power amplifier 2B and the supply modulator 30B. In the present embodiment, the module laminate 390 is an example of the second substrate.

The power amplifier 2B and the supply modulator 30B are arranged on a main surface 390a. The power amplifier 2B is connected to the supply modulator 30B via the wiring W4. The power supply voltage V_{ETB} is supplied from the supply modulator 30B to the power amplifier 2B via the wiring W4.

The power amplifier 2B is mounted in, for example, an integrated circuit. Although the integrated circuit is made of at least one of silicon (Si), gallium arsenide (GaAs), silicon germanium (SiGe), and gallium nitride (GaN), the material of the integrated circuit is not limited to the above materials.

The supply modulator 30B is mounted in an integrated circuit composed, for example, using the CMOS. At this time, the integrated circuit may be manufactured, for example, using the SOI process. The integrated circuit is not limited to the CMOS.

The multiple land electrodes 350 are arranged on the main surface 390b. The multiple land electrodes 350 function as the external connection terminals including the ground terminals, in addition to the input terminals 131B to 134B and 301 and the output terminal 302 illustrated in Fig. 13.

The multiple land electrodes 350 are electrically connected to the input-output terminals, the ground terminals, and/or the likes on the mother board 1000 arranged in the negative direction of the z axis of the PA module 300B. In addition, the multiple land electrodes 350 are electrically connected to the power amplifier 2B and the supply modulator 30B arranged on the main surface 390a via the via conductors and so on formed in the module laminate 390.

The configuration of the PA module 300B according to the present embodiment is only an example and is not limited to this. For example, part of the RFIC 5B or the entire RFIC 5B may be included in the PA module 300B.

Multiple PA modules 300B may be included in the communication device 7. In this case, the tracker module 100A may supply the multiple voltages V1 to V4 to the multiple PA modules 300B. With this configuration, since the tracker module 100A is shared between the multiple power amplifiers 2B, it is effective to reduce the size of the communication device 7.

### [3.3 Advantages and so on]

As described above, the tracker module 100A according to the present embodiment includes the module laminate 90, the integrated circuit 80 arranged on the module laminate 90, and the output terminal 141 that is capable of being externally connected and the multiple output terminals 121 to 124. The integrated circuit 80 includes at least one switch included in the switched-capacitor circuit 20 and at least one switch included in the supply modulator 30A. The switched-capacitor circuit 20 is configured so as to generate the multiple discrete voltages based on the input voltage and to supply the generated multiple discrete voltages to the supply modulator 30A and the multiple output terminals 121 to 124. The supply modulator 30A is configured so as to selectively supply at least one of the multiple discrete voltages generated by the switched-capacitor circuit 20 to the output terminal 141.

With the above configuration, the tracker module 100A is capable of outputting the multiple discrete voltages from the switched-capacitor circuit 20 via the multiple output terminals 121 to 124. Accordingly, it is not necessary to include the supply modulator 30B connected between the switched-capacitor circuit 20 and the power amplifier 2B in the tracker module 100A and, thus, the supply modulator 30B is capable of being kept apart from the switched-capacitor circuit 20. As a result, the supply modulator 30B is capable of being arranged so as to be closer to the power amplifier 2B to shorten the length of the wiring W4 with which the supply modulator 30B is connected to the power amplifier 2B. This reduces the parasitic capacitance, the parasitic inductance, and/or the like of the wiring W4 to suppress the degradation of the power supply voltage V_{ETB}. In addition, according to the present embodiment, the switched-capacitor circuit 20 is capable of being shared between the multiple power amplifiers 2A and 2B to reduce the size of the tracker module 100A, compared with the case in which the analog ET mode requiring the voltage generator for each power amplifier is used.

For example, in the tracker module 100A according to the present embodiment, the supply modulator 30A may be configured so as to control the output voltage based on the envelope signal of the radio-frequency signal S1.

With the above configuration, it is possible to apply the digital ET mode to the power amplifier 2A to improve the PAE.

For example, in the tracker module 100A according to the present embodiment, the module laminate 90 may have the lower side and the upper side that are opposed to each other. The output terminal 141 may be arranged along the lower side and the multiple output terminals 121 to 124 may be arranged along the upper side.

With the above configuration, the output terminal 141 and the output terminals 121 to 124 are arranged along the sides of the module laminate 90, which are opposed to each other. Accordingly, it is possible to improve the degree of freedom of the arrangement of the PA module 200 connected to the output terminal 141 and the PA module 300B connected to the output terminals 121 to 124 to easily shorten the wiring lengths for connecting the PA module 200 and 300B to the tracker module 100A.

For example, in the tracker module 100A according to the present embodiment, the output terminal 141 may be connected to the power amplifier 2A configured so as to amplify the cellular network Sub6 signal or the WLAN 2.4-GHz band signal (the radio-frequency signal S1). The multiple output terminals 121 to 124 may be connected to the power amplifier 2B configured so as to amplify the cellular network millimeter-wave signal (the radio-frequency signal S2) .

With the above configuration, shortening the wiring W4 with which the supply modulator 30B is connected to the power amplifier 2B capable of amplifying the cellular network millimeter-wave signal enables the parasitic capacitance, the parasitic inductance, and/or the like of the wiring W4 to be reduced to suppress the degradation of the power supply voltage V_{ETB}. In particular, since a wider channel band width can be used for the cellular network millimeter-wave signal, the variation with time of the power supply voltage V_{ETB} is increased. Accordingly, the reduction in the parasitic capacitance and/or the parasitic inductance of the wiring W4 has a large effect of suppressing the degradation of the power supply voltage V_{ETB}.

The PA module 300B according to the present embodiment includes the module laminate 390, the power amplifier 2B that is arranged on the module laminate 390 and that is configured so as to amplify the radio-frequency signal S2, the integrated circuit arranged on the module laminate 390, and the multiple input terminals 131B to 134B receiving the multiple voltages V4 to V1, respectively, having the corresponding multiple discrete voltage levels. The integrated circuit includes the supply modulator 30B configured so as to selectively supply at least one of the multiple discrete voltages V4 to V1 received via the multiple input terminals 131B to 134B to the power amplifier 2B based on the radio-frequency signal.

With the above configuration, since both the supply modulator 30B and the power amplifier 2B are arranged on the module laminate 390, the length of the wiring W4 with which the supply modulator 30B is connected to the power amplifier 2B is capable of being shortened. As a result, it is possible to reduce the parasitic capacitance, the parasitic inductance, and/or the like of the wiring W4 to suppress the degradation of the power supply voltage V_{ETB}.

For example, in the PA module 300B according to the present embodiment, the supply modulator 30B may control the output voltage based on the envelope signal of the radio-frequency signal S2.

With the above configuration, it is possible to apply the digital ET mode to the power amplifier 2B to improve the PAE. In addition, since the power supply voltage V_{ETB} is varied to the multiple discrete voltage levels for a short time in the digital ET mode, the reduction in the parasitic capacitance and/or the parasitic inductance of the wiring W4 has a large effect of suppressing the degradation of the power supply voltage V_{ETB}.

For example, in the PA module 300B according to the present embodiment, the radio-frequency signal S2 may be the cellular network millimeter-wave signal.

With the above configuration, shortening the wiring W4 with which the supply modulator 30B is connected to the power amplifier 2B capable of amplifying the cellular network millimeter-wave signal enables the parasitic capacitance, the parasitic inductance, and/or the like of the wiring W4 to be reduced to suppress the degradation of the power supply voltage V_{ETB}. In particular, since a wider channel band width can be used for the cellular network millimeter-wave signal, the variation with time of the power supply voltage V_{ETB} is increased. Accordingly, the reduction in the parasitic capacitance and/or the parasitic inductance of the wiring W4 has a large effect of suppressing the degradation of the power supply voltage V_{ETB}.

### (Fourth embodiment)

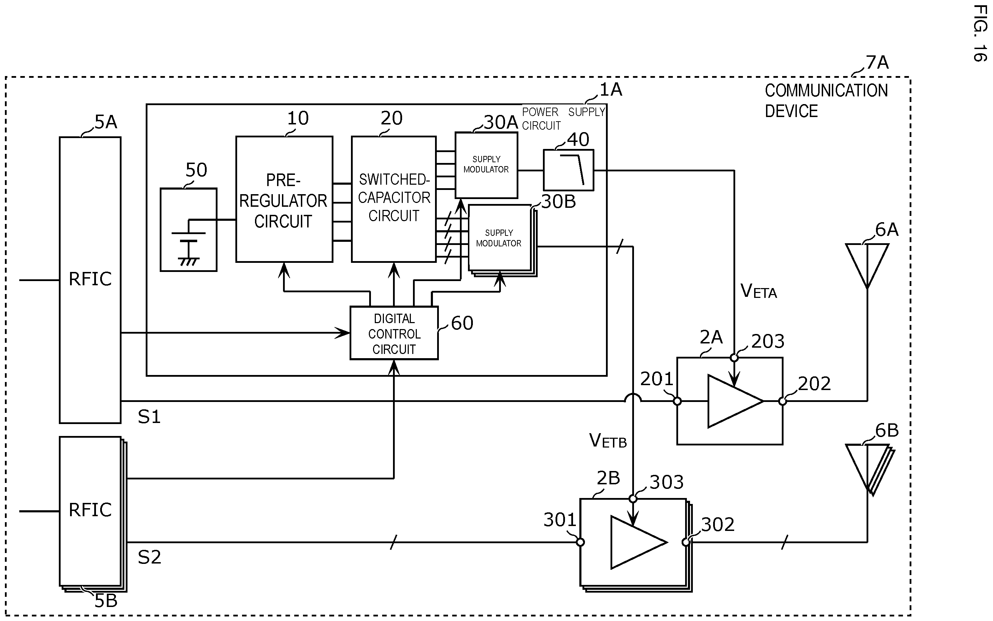

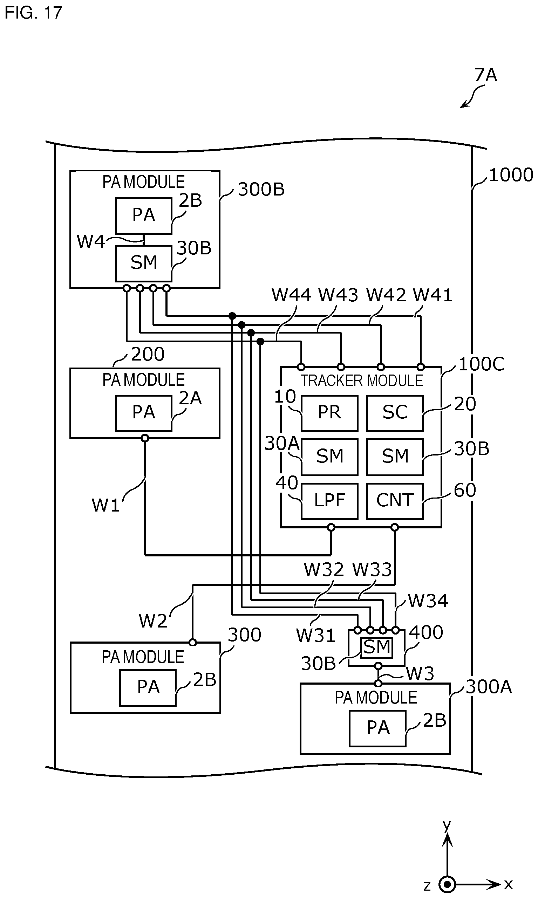

Next, a fourth embodiment will be described. The present embodiment mainly differs from the first to third embodiments in that the four PA modules 200, 300, 300A, and 300B described in the first to third embodiments are included in the communication device. The present embodiment will be described with reference to Fig. 16 and Fig. 17, focusing on points different from the first to third embodiments.

Fig. 16 is a diagram illustrating the circuit configuration of a communication device 7A according to the present embodiment. The communication device 7A according to the present embodiment includes a power supply circuit 1A, the power amplifier 2A, three power amplifiers 2B, the RFIC 5A, three RFICs 5B, the antenna 6A, and three antennas 6B. The three power amplifiers 2B are capable of amplifying the WLAN 2.4-GHz band signal, the WLAN 5-GHz band signal, and the cellular network millimeter-wave signal, respectively.

The power supply circuit 1A includes the pre-regulator circuit 10, the switched-capacitor circuit 20, the supply modulator 30A, three supply modulators 30B, the filter circuit 40, the direct current power source 50, and the digital control circuit 60.

One of the three supply modulators 30B is capable of selectively supplying at least one of the multiple discrete voltages to one of the power amplifiers 2B based on the digital control signal corresponding to the envelope of the WLAN 2.4-GHz band signal. Another one of the supply modulators 30B is capable of selectively supplying at least one of the multiple discrete voltages to another one of the power amplifiers 2B based on the envelope of the WLAN 5-GHz band signal. The remaining one of the supply modulators 30B is capable of selectively supplying at least one of the multiple discrete voltages to the remaining one of the power amplifiers 2B based on the envelope of the cellular network millimeter-wave signal.

Fig. 17 is a diagram illustrating how the modules are arranged on the mother board 1000 in the present embodiment. Illustration of the RFICs 5A and 5B and the antennas 6A and 6B is omitted in Fig. 17. A radio-frequency module according to the present embodiment includes a tracker module 100C, the PA modules 200, 300, 300A, and 300B, and the integrated circuit 400.

The PA module 200 includes the power amplifier 2A capable of amplifying the cellular network Sub6 signal (an example of the first radio-frequency signal). In the present embodiment, the power amplifier 2A in the PA module 200 is an example of the first power amplifier.

The PA module 300 includes the power amplifier 2B capable of amplifying the WLAN 2.4-GHz band signal (an example of the first radio-frequency signal). In the present embodiment, the power amplifier 2B in the PA module 300 is an example of the first power amplifier.

The PA module 300A includes the power amplifier 2B capable of amplifying the WLAN 5-GHz band signal (an example of the second radio-frequency signal). In the present embodiment, the power amplifier 2B in the PA module 300A is an example of the second power amplifier.

The PA module 300B includes the power amplifier 2B capable of amplifying the cellular network millimeter-wave signal (an example a third radio-frequency signal). In the PA module 300B of the present embodiment, the power amplifier 2B is an example of a third power amplifier. In the PA module 300B of the present embodiment, the module laminate 390 is an example of a third substrate, the supply modulator 30B is an example of a third supply modulator, the integrated circuit including the supply modulator 30B is an example of a third integrated circuit, and the input terminals 131B to 134B are an example of multiple second input terminals.

The integrated circuit 400 is an example of a second integrated circuit. The integrated circuit 400 includes the supply modulator 30B (an example of the second supply modulator) and is arranged on the mother board 1000. In the present embodiment, the input terminals 131B to 134B of the integrated circuit 400 are an example of the multiple first input terminals. The mother board 1000 is an example of the second substrate.

The tracker module 100C is capable of supplying the voltage to the PA modules 200, 300, 300A, and 300B and includes the pre-regulator circuit 10 (PR), the switched-capacitor circuit 20 (SC), the supply modulators 30A and 30B (SM), the filter circuit 40 (LPF), and the digital control circuit 60 (CNT).

In the tracker module 100C of the present embodiment, the module laminate 90 is an example of the first substrate, the integrated circuit 80 is an example of a first integrated circuit, each of the supply modulators 30A and 30B is an example of the first supply modulator, the output terminal 141 is an example of the first output terminal, and the output terminals 121 to 124 are an example of the multiple second output terminals.

Specifically, the tracker module 100C is connected to the PA modules 200 and 300 via the wirings W1 and W2, respectively, and is capable of supplying the voltages selected in the supply modulators 30A and 30B to the PA modules 200 and 300, respectively. In addition, the tracker module 100C is connected to the integrated circuit 400 via the wirings W31 to W34 (an example of multiple first wirings) and is capable of applying the voltages V1 to V4 having the corresponding multiple discrete voltage levels generated in the switched-capacitor circuit 20 to the integrated circuit 400. Furthermore, the tracker module 100C is connected to the PA module 300B via the wirings W41 to W44 (an example of multiple second wirings) and is capable of applying the voltages V1 to V4 having the corresponding multiple discrete voltage levels generated in the switched-capacitor circuit 20 to the PA module 300B.

The length of the wiring W44 may be shorter than the length of the wiring W34, and the width of the wiring W44 may be wider than the width of the wiring W34. Similarly, the length of the wiring W43 may be shorter than the length of the wiring W33, and the width of the wiring W43 may be wider than the width of the wiring W33. The length of the wiring W42 may be shorter than the length of the wiring W32, and the width of the wiring W42 may be wider than the width of the wiring W32. The length of the wiring W41 may be shorter than the length of the wiring W31, and the width of the wiring W41 may be wider than the width of the wiring W31.

The length of the wiring W34 to which the highest voltage V4 is applied, among the wirings W31 to W34, may be shorter than the length of the wiring W31 to which the lowest voltage V1 is applied, among the wirings W31 to W34, and the width of the wiring W34 may be wider than the width of the wiring W31. Similarly, the length of the wiring W44 to which the highest voltage V4 is applied, among the wirings W41 to W44, may be shorter than the length of the wiring W41 to which the lowest voltage V1 is applied, among the wirings W41 to W44, and the width of the wiring W44 may be wider than the width of the wiring W41.

As described above, the radio-frequency module according to the present embodiment includes the first substrate (the module laminate 90) having the multiple output terminals 121 to 124, the second substrate (the mother board 1000) having the multiple input terminals 131B to 134B connected to the multiple output terminals 124 to 121, respectively, the integrated circuit 80 that includes at least one switch included in the switched-capacitor circuit 20 and that is arranged on the first substrate, and the integrated circuit 400 that includes at least one switch included in the supply modulator 30B and that is arranged on the second substrate. The switched-capacitor circuit 20 is configured so as to generate the multiple discrete voltages based on the input voltage and to supply the generated multiple discrete voltages to the multiple output terminals. The supply modulator 30B is configured so as to selectively output at least one of the multiple discrete voltages received via the multiple input terminals 131B to 134B.

With the above configuration, since it is not necessary to mount the integrated circuit 80 including at least one switch included in the switched-capacitor circuit 20 and the integrated circuit 400 including the supply modulator 30B on the same substrate, the supply modulator 30B is capable of being kept apart from the switched-capacitor circuit 20. As a result, the supply modulator 30B is capable of being arranged so as to be closer to the power amplifier 2B to shorten the length of the wiring W3 with which the supply modulator 30B is connected to the power amplifier 2B. This reduces the parasitic capacitance, the parasitic inductance, and/or the like of the wiring W3 to suppress the degradation of the power supply voltage V_{ETB}.

For example, in the radio-frequency module according to the present embodiment, the supply modulator 30B may be configured so as to control the output voltage based on the envelope signal.

With the above configuration, it is possible to apply the digital ET mode to the power amplifier 2B to improve the PAE. In addition, since the power supply voltage V_{ETB} is varied to the multiple discrete voltage levels for a short time in the digital ET mode, the reduction in the parasitic capacitance and/or the parasitic inductance of the wiring W3 or W4 has a large effect of suppressing the degradation of the power supply voltage V_{ETB}.

For example, in the radio-frequency module according to the present embodiment, the first substrate (the module laminate 90) may further have the output terminal 141. The integrated circuit 80 may further include at least one switch included in the supply modulator 30A. The supply modulator 30A may be configured so as to selectively supply at least one of the multiple discrete voltages to the output terminal 141 based on the radio-frequency signal S1.

With the above configuration, the switched-capacitor circuit 20 is capable of being shared between the multiple power amplifiers 2A and 2B to reduce the size of the tracker module 100C, compared with the case in which the analog ET mode requiring the voltage generator for each power amplifier is used.

For example, in the radio-frequency module according to the present embodiment, the output terminal 141 may be connected to the power amplifier 2A configured so as to amplify the cellular network Sub6 signal or the WLAN 2.4-GHz band signal. The multiple output terminals 121 to 124 may be connected to the power amplifier 2B configured so as to amplify the cellular network millimeter-wave signal or the WLAN 5-GHz band signal.

With the above configuration, shortening the wiring W3 or W4 with which the supply modulator 30B is connected to the power amplifier 2B capable of amplifying the WLAN 5-GHz band signal or the cellular network millimeter-wave signal enables the parasitic capacitance, the parasitic inductance, and/or the like of the wiring W3 or W4 to be reduced to suppress the degradation of the power supply voltage V_{ETB}. In particular, since a wider channel band width can be used for the WLAN 5-GHz band signal or the cellular network millimeter-wave signal, the variation with time of the power supply voltage V_{ETB} is increased. Accordingly, the reduction in the parasitic capacitance and/or the parasitic inductance of the wiring W3 has a large effect of suppressing the degradation of the power supply voltage V_{ETB}.

For example, the radio-frequency module according to the present embodiment may further include the third substrate (the module laminate 390 of the PA module 300B) having the multiple input terminals 131B to 134B connected to the multiple output terminals 124 to 121, respectively, and the integrated circuit (the integrated circuit included in the PA module 300B) that includes at least one switch included in the supply modulator 30B and that is arranged on the third substrate. The supply modulator 30B may be configured so as to selectively output at least one of the multiple discrete voltages received via the multiple input terminals 131B to 134B.

With the above configuration, the switched-capacitor circuit 20 is capable of being shared between the multiple power amplifiers 2A and 2B to reduce the size of the tracker module 100C, compared with the case in which the analog ET mode requiring the voltage generator for each power amplifier is used.

For example, in the radio-frequency module according to the present embodiment, the output terminal 141 may be connected to the power amplifier 2A configured so as to amplify the cellular network Sub6 signal. The multiple output terminals 121 to 124 may be connected to the power amplifier 2B of the PA module 300A configured so as to amplify the WLAN 5-GHz band signal via the multiple input terminals 131B to 134B of the second substrate and the supply modulator 30B and may be connected to the power amplifier 2B of the PA module 300B configured so as to amplify the cellular network millimeter-wave signal via the multiple input terminals 131B to 134B of the third substrate and the supply modulator 30B.

With the above configuration, shortening the wirings W3 and W4 with which the two supply modulators 30B are connected to the two power amplifiers 2B capable of amplifying the WLAN 5-GHz band signal and the cellular network millimeter-wave signal, respectively, enables the parasitic capacitances, the parasitic inductances, and/or the likes of the wirings W3 and W4 to be reduced to suppress the degradation of the two power supply voltages V_{ETB} for the two power amplifiers 2B. In particular, since wider channel band widths can be used for the WLAN 5-GHz band signal and the cellular network millimeter-wave signal, the variation with time of the power supply voltages V_{ETB} is increased. Accordingly, the reduction in the parasitic capacitances and/or the parasitic inductances of the wiring W3 and W4 has a large effect of suppressing the degradation of the power supply voltages V_{ETB}.

For example, in the radio-frequency module according to the present embodiment, the multiple input terminals 131B to 134B of the integrated circuit 400 may be connected to the multiple output terminals 121 to 124 via the multiple wirings W31 to W34. The multiple input terminals 131B to 134B of the PA module 300B may be connected to the multiple output terminals 121 to 124 via the multiple wirings W41 to W44. The length of each of the multiple wirings W41 to W44 may be shorter than the length of each of the multiple wirings W31 to W34.

With the above configuration, since the length of each of the multiple wirings W41 to W44 is shorter than the length of each of the multiple wirings W31 to W34, it is possible to make the parasitic resistances of the multiple wirings W41 to W44 lower than the parasitic resistances of the multiple wirings W31 to W34. Since higher output power is required in the cellular network than the WLAN, current flowing through the multiple wirings W41 to W44 is larger than that flowing through the multiple wirings W31 to W34. Accordingly, making the parasitic resistances of the multiple wirings W41 to W44 lower than the parasitic resistances of the multiple wirings W31 to W34 enables resistance loss due to the wirings to be more effectively reduced.

For example, in the radio-frequency module according to the present embodiment, the width of each of the multiple wirings W41 to W44 may be wider than the width of each of the multiple wirings W31 to W34.

With the above configuration, since the width of each of the multiple wirings W41 to W44 is wider than the width of each of the multiple wirings W31 to W34, it is possible to make the parasitic resistances of the multiple wirings W41 to W44 lower than the parasitic resistances of the multiple wirings W31 to W34. Since higher output power is required in the cellular network than the WLAN, current flowing through the multiple wirings W41 to W44 is larger than that flowing through the multiple wirings W31 to W34. Accordingly, making the parasitic resistances of the multiple wirings W41 to W44 lower than the parasitic resistances of the multiple wirings W31 to W34 enables the resistance loss due to the wirings to be more effectively reduced.

For example, in the radio-frequency module according to the present embodiment, the length of the wiring W34 to which the highest voltage V4 is applied, among the multiple wirings W31 to W34, may be shorter than the length of the wiring W31 to which the lowest voltage V1 is applied, among the multiple wirings W31 to W34.

With the above configuration, since the length of the wiring W34 is shorter than the length of the wiring W31, it is possible to make the parasitic resistance of the wiring W34 lower than the parasitic resistance of the wiring W31. Current flowing through the wiring W34 to which the highest voltage V4 is applied is larger than that flowing through the wiring W31 to which the lowest voltage V1 is applied. Accordingly, making the parasitic resistance of the wiring W34 lower than the parasitic resistance of the wiring W31 enables the resistance loss due to the wirings to be more effectively reduced.

For example, in the radio-frequency module according to the present embodiment, the width of the wiring W34 to which the highest voltage V4 is applied, among the multiple wirings W31 to W34, may be wider than the width of the wiring W31 to which the lowest voltage V1 is applied, among the multiple wirings W31 to W34.

With the above configuration, since the width of the wiring W34 is wider than the width of the wiring W31, it is possible to make the parasitic resistance of the wiring W34 lower than the parasitic resistance of the wiring W31. Current flowing through the wiring W34 to which the highest voltage V4 is applied is larger than that flowing through the wiring W31 to which the lowest voltage V1 is applied. Accordingly, making the parasitic resistance of the wiring W34 lower than the parasitic resistance of the wiring W31 enables the resistance loss due to the wirings to be more effectively reduced.

### (Fifth embodiment)

Next, a fifth embodiment will be described. The present embodiment mainly differs from the fourth embodiment described above in that two supply modulators 30B are included in one SW module. The present embodiment will be described with reference to Fig. 17, focusing on points different from the fourth embodiment.

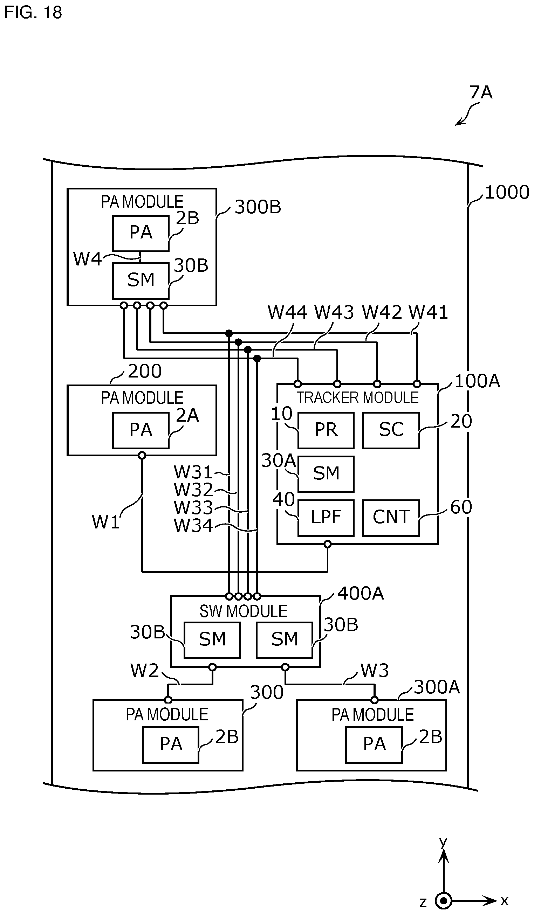

Fig. 18 is a diagram illustrating how the modules are arranged on the mother board 1000 in the present embodiment. Illustration of the RFICs 5A and 5B and the antennas 6A and 6B is omitted in Fig. 18.

An SW module 400A includes the two supply modulators 30B. The SW module 400A is two integrated circuits composed of, for example, using the CMOS and is arranged on the module laminate. The two integrated circuits may be manufactured, for example, using the SOI process. The two integrated circuits may be integrated into one integrated circuit.

In the present embodiment, the module laminate of the SW module 400A is examples of the second substrate and the third substrate. In other words, the second substrate and the third substrate are the same substrate in the present embodiment. With this configuration, since the multiple supply modulators 30A and 30B are capable of being mounted on the two substrates, it is possible to contribute to reduction in size of the communication device 7A.

In the present embodiment, the supply modulator 30B included in the PA module 300B may also be included in the SW module 400A.

### (Other embodiments)

Although the tracker modules, the power amplifier module, and the radio-frequency module according to the present invention are described based on the embodiments, the tracker modules, the power amplifier module, and the radio-frequency module according to the present invention are not limited to the above embodiments. Other embodiments realized by combining arbitrary components in the above embodiments, modifications achieved by making various modifications supposed by the person skilled in the art to the above embodiments without departing from the spirit and scope of the present invention, and various devices incorporating the power supply circuits described above are also included in the present invention.

For example, in the circuit configurations of the various circuits according to the above embodiments, other circuit elements, lines, and so on may be provided between the paths with which the respective circuit elements and signal lines disclosed in the drawings are connected. For example, a filter may be provided between the power amplifier 2A and the antenna 6A and/or a filter may be provided between the power amplifier 2B and the antenna 6B.

Although the digital ET mode is used in the above respective embodiments, the SPT mode may be used, instead of the digital ET mode.

Although the power supply circuits 1 and 1A supply the power supply voltage to the power amplifier capable of amplifying the 5GNR Sub6 signal in the above respective embodiments, the power supply circuits 1 and 1A may supply the power supply voltage to the power amplifier capable of amplifying an LTE signal, in addition to the power amplifier capable of amplifying the 5GNR Sub6 signal or instead of the power amplifier capable of amplifying the 5GNR Sub6 signal.

Although the multiple voltages having the corresponding multiple discrete voltage levels are supplied from the switched-capacitor circuit to the supply modulators in the above respective embodiments, the supply of the multiple voltages is not limited to this. For example, the multiple voltages may be supplied from the respective multiple DC-DC converters. When the multiple discrete voltage levels are set at equal intervals, the switched-capacitor circuit is preferably used. This is effective for reduction in size of the tracker module.

The power supply voltages having the four variable discrete voltage levels are supplied in the above respective embodiments, the number of the discrete voltage levels is not limited to four. For example, if at least the voltage level corresponding to the maximum output power and the voltage level corresponding to the output power having the highest frequency of occurrence are included in the multiple discrete voltage levels, it is possible to effectively improve the PAE.

Although the power supply circuits 1 and 1A each include the two or four supply modulators in the above respective embodiments, the number of the supply modulators is not limited to these numbers. An arbitrary number of the supply modulators may be connected to one switched-capacitor circuit.

Although the cellular network Sub6 signal and millimeter-wave signal and the WLAN 2.4-GHz band and WLAN 5-GHz band signals are used as the radio-frequency signals S1 and S2 in the above respective embodiments, the radio-frequency signals S1 and S2 are not limited to the above ones. For example, a WLAN 6-GHz band and/or 7-GHz band signal may be used as the radio-frequency signal S1 and/or S2. Alternatively, for example, a cellular network Frequency Range 3 (FR3) signal may be used as the radio-frequency signal S1 and/or S2. Alternatively, for example, a radar signal may be used as the radio-frequency signal S1 and/or S2.

In radio technology, it is possible to improve the data rate or to improve another aspect of the connection performance by using multiple concurrent wireless transmissions in general. For example, in a Multiple-Input and Multiple-Output (MIMO) approach, multiple concurrent wireless signal transmissions are used at the same frequency. In another example, in Carrier Aggregation (CA), multiple concurrent wireless signal transmissions at different frequencies are used in a cellular application. In another example, in a Concurrent Dual Band (CDB) operation, multiple transmissions at different frequencies are used in a WLAN application.

Such multiple concurrent wireless transmission signals may be used as the radio-frequency signals S1 and S2, an additional radio-frequency signal, or an arbitrary combination of these signals. For example, multiple FR1 or FR2 signals for the CA or E-UTRAN New Radio-Dual Connectivity (ENDC) of the cellular network may be used as the radio-frequency signals S1 and S2, an additional radio-frequency signal, or an arbitrary combination of these signals. Alternatively, for example, the multiple FR1 of FR2 signals for dual Subscriber Identity Module (SIM) or the MIMO of the cellular network may be used as the radio-frequency signals S1 and S2, an additional radio-frequency signal, or an arbitrary combination of these signals. Alternatively, for example, multiple signals for the MIMO or the CDB of the WLAN may be used as the radio-frequency signals S1 and S2, an additional radio-frequency signal, or an arbitrary combination of these signals. Alternatively, for example, the FR1, FR2, and FR3 signals of the cellular network may be used as the radio-frequency signals S1 and S2, an additional radio-frequency signal, or an arbitrary combination of these signals.

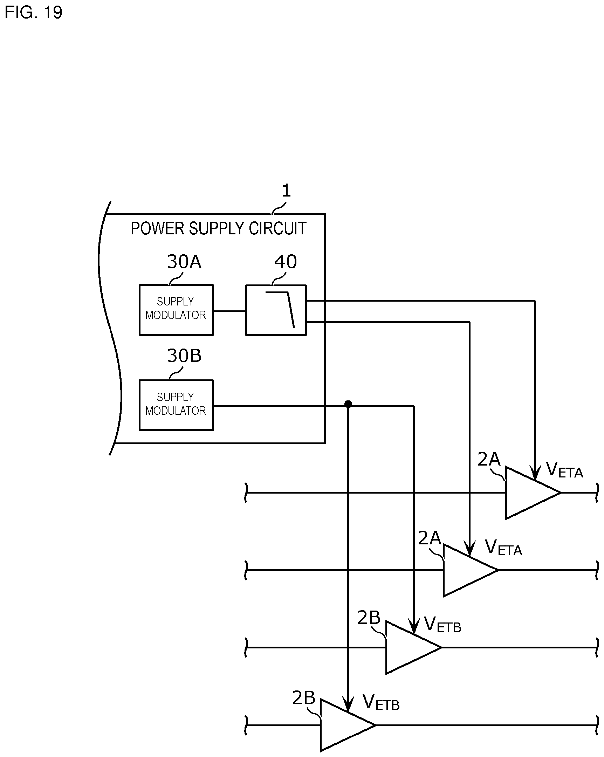

Although each of the supply modulators 30A and 30B is connected to one power amplifier in the above respective embodiments, each of the supply modulators 30A and 30B may be connected to multiple power amplifiers. For example, referring to Fig. 19, the supply modulator 30A is capable of selectively supplying the power supply voltage V_{ETA} to the two power amplifiers 2A and the supply modulator 30B is capable of concurrently supplying the power supply voltage V_{ETB} to the two power amplifiers 2B amplifying the same modulated radio-frequency signal.

### Industrial Applicability

The present invention is widely usable for a communication device, such as a mobile phone, as the power supply circuit supplying the power supply voltage to the power amplifier.

### Reference Signs List

1, 1A power supply circuit
2A, 2B power amplifier
5A, 5B RFIC
6A, 6B antenna
7, 7A communication device
10 pre-regulator circuit
20 switched-capacitor circuit
30A, 30B supply modulator
40 filter circuit
50 direct current power source
60 digital control circuit
61 first controller
62 second controller
80, 400 integrated circuit
80a PR switch portion
80b SC switch portion
80cA, 80cB SM switch portion
80d digital control portion
90, 290, 390 module laminate
90a, 90b, 290a, 290b, 390a, 390b main surface
90b1 central area
90b2 outer peripheral area
91 resin member
93 shield electrode layer
94 ground plane
100, 100A, 100C tracker module
110, 131A, 131B, 132A, 132B, 133A, 133B, 134A, 134B, 140, 201, 301 input terminal
111, 112, 113, 114, 121, 122, 123, 124, 130A, 130B, 141, 202, 302 output terminal
150, 151, 152, 153, 250, 350 land electrode
200, 300, 300A, 300B PA module
203, 303 power supply terminal
400A SW module
601, 602, 603, 604, 605, 606 control terminal
1000 mother board
C10, C11, C12, C13, C14, C15, C16, C20, C30, C40, C51, C52, C61, C62, C63, C64 capacitor
L51, L52, L53 inductor
L71 power inductor
N1, N2, N3, N4 node
R51 resistor
CS1, CS2, CS3A, CS3B control signal
S1, S2 radio-frequency signal
S11, S12, S13, S14, S21, S22, S23, S24, S31, S32, S33, S34, S41, S42, S43, S44, S51A, S51B, S52A, S52B, S53A, S53B, S54A, S54B, S61, S62, S63, S71, S72 switch
V1, V2, V3, V4 voltage
V_{ETA}, V_{ETB} power supply voltage
W1, W2, W3, W4, W31, W32, W33, W34, W41, W42, W43, W44 wiring

## Claims

1. A tracker module comprising:
a module laminate;
at least one integrated circuit arranged on the module laminate; and
a first output terminal that is capable of being externally connected and a plurality of second output terminals,
wherein the at least one integrated circuit includes at least one switch included in a switched-capacitor circuit and at least one switch included in a first supply modulator,
wherein the switched-capacitor circuit is configured so as to generate a plurality of discrete voltages based on input voltage and to supply the generated plurality of discrete voltages to the first supply modulator and the plurality of second output terminals, and
wherein the first supply modulator is configured so as to selectively supply at least one of the plurality of discrete voltages generated by the switched-capacitor circuit to the first output terminal.

2. The tracker module according to Claim 1,
wherein the first supply modulator is configured so as to control output voltage based on an envelope signal of a first radio-frequency signal.

3. The tracker module according to Claim 1 or 2,
wherein the module laminate has a first side and a second side that are opposed to each other,
wherein the first output terminal is arranged along the first side, and
wherein the plurality of second output terminals is arranged along the second side.

4. The tracker module according to any of Claims 1 to 3,
wherein the first output terminal is connected to a first power amplifier configured so as to amplify a cellular network Sub6 signal or a wireless local area network 2.4-GHz band signal, and
wherein the plurality of second output terminals is connected to a second power amplifier configured so as to amplify a cellular network millimeter-wave signal or a wireless local area network 5-GHz band signal.

5. A power amplifier module comprising:
a module laminate;
a power amplifier that is arranged on the module laminate and that is configured so as to amplify a radio-frequency signal;
an integrated circuit arranged on the module laminate; and
a plurality of input terminals receiving a corresponding plurality of discrete voltages,
wherein the integrated circuit includes a supply modulator configured so as to selectively supply at least one of the plurality of discrete voltages received via the plurality of input terminals to the power amplifier based on the radio-frequency signal.

6. The power amplifier module according to Claim 5,
wherein the supply modulator is configured so as to control output voltage based on an envelope signal of the radio-frequency signal.

7. The power amplifier module according to Claim 5 or 6,
wherein the radio-frequency signal is a cellular network millimeter-wave signal.

8. A radio-frequency module comprising:
a first substrate having a plurality of output terminals;
a second substrate having a plurality of first input terminals connected to the corresponding plurality of output terminals;
a first integrated circuit that includes at least one switch included in a switched-capacitor circuit and that is arranged on the first substrate; and
a second integrated circuit that includes at least one switch included in a supply modulator and that is arranged on the second substrate,
wherein the switched-capacitor circuit is configured so as to generate a plurality of discrete voltages based on input voltage and to supply the generated plurality of discrete voltages to the plurality of output terminals, and
wherein the supply modulator is configured so as to selectively output at least one of the plurality of discrete voltages received via the plurality of first input terminals.

9. The radio-frequency module according to Claim 8,
wherein the supply modulator is configured so as to control output voltage based on an envelope signal.

10. The radio-frequency module according to Claim 8 or 9,
wherein the supply modulator is a second supply modulator,
wherein the plurality of output terminals is a plurality of second output terminals,
wherein the first substrate further has a first output terminal,
wherein the first integrated circuit further includes at least one switch included in a first supply modulator, and
wherein the first supply modulator is configured so as to selectively supply at least one of the plurality of discrete voltages to the first output terminal based on a first radio-frequency signal.

11. The radio-frequency module according to Claim 10,
wherein the first output terminal is connected to a first power amplifier configured so as to amplify a cellular network Sub6 signal or a wireless local area network 2.4-GHz band signal, and
wherein the plurality of second output terminals is connected to a second power amplifier configured so as to amplify a cellular network millimeter-wave signal or a wireless local area network 5-GHz band signal via the plurality of first input terminals and the second supply modulator.

12. The radio-frequency module according to Claim 10, further comprising:
a third substrate having a plurality of second input terminals connected to the corresponding plurality of second output terminals; and
a third integrated circuit that includes at least one switch included in a third supply modulator and that is arranged on the third substrate,
wherein the third supply modulator is configured so as to selectively output at least one of the plurality of discrete voltages received via the plurality of second input terminals.

13. The radio-frequency module according to Claim 12,
wherein the first output terminal is connected a first power amplifier configured so as to amplify a cellular network Sub6 signal, and
wherein the plurality of second output terminals is connected to a first power amplifier configured so as to amplify a wireless local area network 5-GHz band signal via the plurality of first input terminals and the second supply modulator and is connected to a third power amplifier configured so as to amplify a cellular network millimeter-wave signal via the plurality of second input terminals and the third supply modulator.

14. The radio-frequency module according to Claim 13,
wherein the plurality of first input terminals is connected to the plurality of second output terminals via a plurality of first wirings,
wherein the plurality of second input terminals is connected to the plurality of second output terminals via a plurality of second wirings, and
wherein a length of each second wiring is shorter than a length of each first wiring.

15. The radio-frequency module according to Claim 13,
wherein the plurality of first input terminals is connected to the plurality of second output terminals via a plurality of first wirings,
wherein the plurality of second input terminals is connected to the plurality of second output terminals via a plurality of second wirings, and
wherein a width of each second wiring is wider than a width of each first wiring.

16. The radio-frequency module according to Claim 13,
wherein the plurality of first input terminals is connected to the plurality of second output terminals via a plurality of first wirings, and
wherein a length of the first wiring to which highest second voltage is applied, among the plurality of first wirings, is shorter than a length of the first wiring to which lowest second voltage is applied, among the plurality of first wirings.

17. The radio-frequency module according to Claim 13,
wherein the plurality of first input terminals is connected to the plurality of second output terminals via a plurality of first wirings, and
wherein a width of the first wiring to which highest voltage is applied, among the plurality of first wirings, is wider than a width of the first wiring to which lowest voltage is applied, among the plurality of first wirings.

18. The radio-frequency module according to any of Claims 12 to 17,
wherein the second substrate and the third substrate are one same substrate.
